# EUROPEAN PATENT SPECIFICATION

(11) **EP 0 402 793 B1**
(45) Date of publication and mention of the grant of the patent: **09.04.1997**
(21) Application number: 90110908.2
(22) Date of filing: 08.06.1990
(51) Int. Cl.: H01L 25/16

(54) **Hybrid integrated circuit device**
Integrierte Hybridschaltungsanordnung
Dispositif à circuit intégré hybride

(30) Priority: 15.06.1989 JP 153271/89; 16.06.1989 JP 155087/89; 19.06.1989 JP 156223/89; 20.06.1989 JP 157336/89; 20.06.1989 JP 157367/89
(43) Date of publication of application: 19.12.1990
(73) Proprietor: SANYO ELECTRIC CO., LTD., Moriguchi-shi, Osaka (JP)
(72) Inventor: Saitou, Yasuo, Nitta-gun, Gunma (JP); Kazami, Akira, Ashikaga-shi, Tochigi (JP); Nakamoto, Osamu, Ohta-shi, Gunma (JP); Shimizu, Hisashi, Ohta-shi, Gunma (JP); Ohkawa, Katsumi, Ohta-shi, Gunma (JP); Koike, Yasuhiro, Nitta-gun, Gunma (JP); Nagahama, Koji, Ohta-shi, Gunma (JP); Kaneko, Masao, Maebashi-shi, Gunma (JP); Ueno, Masakazu, Ohta-shi, Gunma (JP)
(74) Representative: Wächtershäuser, Günter, Prof. Dr.

(56) References cited:
- ELECTRONIC PACKAGING & PRODUCTION, vol. 28, no. 6, June 1988, pages 80-81; D.B. WHITNEY: "Chip-on-board yields inexpensive microcontroller"
- PATENT ABSTRACTS OF JAPAN, vol. 8, no. 272 (E-284)[1709], 13th December 1984; & JP-A-59 141 258

## Description

### Field of the Invention:

The present invention relates to a hybrid integrated circuit device with a built-in microcomputer and a built-in non-volatile memory which feeds data to the microcomputer, in particular, to a hybrid integrated circuit device provided with a non-volatile memory to which the writing of data can be performed with extreme ease.

### Description of the Background Art:

It is known that multi-functional operation can be realized by using a microcomputer. Recently, microcomputers are therefore used in various fields such as electronics, airplanes, various machines, motor cars, and the like. Contemporary instruments in the above specified fields have the tendency to become more multi-functional. Accordingly, more massive program data is required to control the operation of microcomputers used in these fields.

Such massive program is usually completed through the process of amending the program normally a few times or maximally dozens times because of changing or modifying of specifications or for other reasons in the developing of an instrument. In the first stage of developing an instrument, it is general that program data is provided to a microcomputer by a non-volatile memory capable of being rewritten. A change of the program is, however often required even in an actual test stage using a read-only memory after the developing stage using non-volatile memory. Integrated circuit devices to which rewriting can be readily carried out are therefore desired.

Non-volatile memories are provided with an ultraviolet light irradiation window on its surface by which it is possible to erase stored data written on a chip by ultraviolet irradiation and rewrite into that memory. They are preferably used, particularly in the developing stage, in various types of electronic devices. Usually, these non-volatile memories are detachably mounted on a printed board for subsequent rewriting. Most of these non-volatile memories are mounted together with a control- or drive-integrated circuit on a printed board.

For electronic devices which must be small and lightweight, a technique known as "chip-on-board" is adopted, wherein a semiconductor integrated circuit (IC) chip is directly mounted on a printed board, and after the required wiring is implemented, the IC chip and the wiring section are covered with a synthetic resin. However, in an electronic device for which a non-volatile memory is required, because it must be possible to erase the stored data by directing ultraviolet light onto the non-volatile memory, and to rewrite into it, the chip-on-board technique in which a non-volatile memory chip is mounted directly on a printed board and covered with a synthetic resin cannot be adopted. For this reason, in an electronic device for which an non-volatile memory is required, there is no other choice but to use a non-volatile memory incorporated in a SADIP-type package. The development of a small-size, light-weight unit is hence impeded.

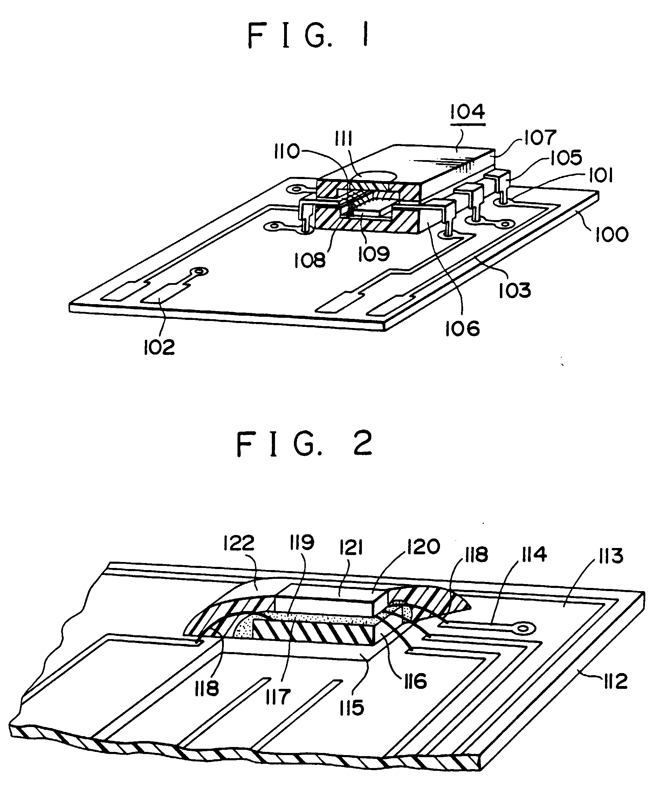

Fig. 1 is a perspective drawing of a non-volatile memory substrate, which explains the mounting structure of a conventional non-volatile memory. One part of a non-volatile memory 104 is shown in section.

A plurality of through-hole terminals 101 and a plurality of male connector terminals 102 made of a conductive material are formed on the main surface of an insulating substrate 100 made from glass-epoxy resin or other similar material. In addition, a conductive wire pattern 103 is also formed, mutually connected to the through-hole terminals 101 and the male connector terminals 102. An external conductive lead 105 of the non-volatile memory 104 incorporated into a SADIP-type package is inserted through the through-hole terminal 101 and electrically connected by soldering to the through-hole terminal 101. In addition, the package into which the non-volatile memory 104 is incorporated is mechanically secured to the insulated substrate 100.

The non-volatile memory 104 is provided with a ceramic header 106 and a ceramic cap 107. The external conductive lead 105 is bonded to the header 106 using a glass material with a low melting point. An element mounting section 108 which is produced from a sintered gold paste made up of a large quantity of gold powder mixed with glass is also bonded directly to the header 106, or indirectly to the header 106 through the low melting point glass material which is extended to the element mounting section 108. A non-volatile memory chip 109 with an ultraviolet emitting surface on the top is mounted on the element mounting section 108. An electrode of the non-volatile chip 109 is connected to the external conductive lead 105 with a fine metal wire 110. The cap 107 is a cover member provided with a window 111 vis-a-vis the ultraviolet emitting surface of the non-volatile memory chip 109. The cap 107 is bonded to the header 106 using a low melting point glass, and it seals the non-volatile memory chip 109 which is positioned on the header 106. The non-volatile memory substrate having the above structure is formed independently of the main circuit print board. The non-volatile memory 104 is connected to a microcomputer or the like mounted on the main circuit print board. This connection is made through the external conductive lead 105, the through hole terminal 101, the conductive wire pattern 103, a male connector terminal 102, and a female connector (omitted from the drawings).

When such a conventional non-volatile memory mounting method is used, the external form of a package is extremely large in comparison with the non-volatile memory chip 109. In addition to occupying a large area in plan view, the height of the elements is also several times the height of the chip, which is a severe handicap in providing a thin-type printed board. After the external conductive lead 105 is inserted into the through hole terminal 101, the non-volatile memory must be secured by solder or the like. In addition, a particularly troublesome drawback is the fact that, before mounting on the insulated substrate, the non-volatile memory must once be assembled in the package. Because the non-volatile memory is provided with an ultraviolet-light emitting window, the package is assembled in a SADIP-type package with a ceramic material and, because this package is sealed in low melting point glass, a high temperature (400°C to 500°C) sealing process is adopted. If the electrode (aluminum) of the non-volatile memory chip and the fine metal wire which connects the electrodes (aluminum) of the non-volatile memory chip to the external conductive lead are not made from the same type of material, an alloy is produced at the joint of the electrodes and the external conductive lead during the high temperature sealing process and the resistance of the wire increases. This can cause the wire to break. A fine aluminum wire is usually used to avoid this kind of trouble. However, in this non-volatile memory chip, the earth electrode of the non-volatile memory chip is wired to the mounting section of the chip which is formed with gold paste, because the substrate of the non-volatile memory chip must bear earth potential. Here as well, there is a tendency for a binary or multiple alloy reaction to occur between the gold in the gold paste and/or the metal in the metal foil or the like, and the aluminum.

For the above reason, a small silicon leaf covered with aluminum on the head referred to as a gland die, is attached to the chip mounting section formed from the gold paste, and the earth electrode of the non-volatile memory chip is connected to the top of the gland die. The conventional mounting structure has many drawbacks accompanied by the above complicated process. Thus, the conventional mounting structure does not satisfy any of the requirements for small size, light weight, and low cost.

The non-volatile memory mounting structure shown in Fig. 2 has been proposed to eliminate this type of problem. This mounting structure will now be explained with reference to the drawing.

A wiring pattern 114 is formed on a main surface of an insulated substrate 112 made from a glass-epoxy resin or other similar material. A chip mounting area 115 which supports a non-volatile memory chip 116 is provided on the insulated substrate 112. The wiring pattern 114 is routed on the main surface 113 from a point close to the area 115 and is connected to a male connector terminal (omitted from the drawing). The non-volatile memory chip 116 is mounted on the area 115. A surface electrode of the non-volatile memory chip 116 is connected to the wiring pattern 114 by a fine metal wire 118. The substrate of the non-volatile memory chip 116 as well is connected to the mounted wiring pattern 114 by one strand of the fine metal wire 118. An ultraviolet-light transmitting window material 120 is secured on the ultraviolet-light emitting surface 117 of the non-volatile memory chip 116 through an ultraviolet-light transmitting resin 119 [for example, TX-978 (trademark), manufactured by Toray].

The window material 120 is made from a commonly known ultraviolet-light transmitting material such as quartz, transparent alumina, or the like. The top surface 121 of the window material 120 is a surface which introduces light to the ultraviolet-light emitting surface 117 of the non-volatile memory chip 116. The part of the window material 120 other than the top surface 121, the fine metal wire 118, and the part connecting the fine metal wire 118 with the wiring pattern 114 are covered with a synthetic resin 122 [for example, MP-10 (trademark), manufactured by Nitto Denko Corp.]. If the base of the chip mounting area 115 of the substrate 112 is situated on a concave at about half the height of the substrate 112, it is possible to further reduce the combined thickness of the insulated substrate 112, the non-volatile memory chip 116, and the window material 120, while formation of a flood gate by the synthetic resin 122 effectively prevents moisture from entering. The non-volatile memory mounting structures shown in Fig. 1 and Fig. 2 are disclosed in Japanese Patent Application Laid-open No. 83393/1985 (H05K 1/18).

Because the non-volatile memory chip is die-bonded to the printed board in the non-volatile memory mounting structure shown in Fig. 2, the printed board is reduced in size by only the amount of reduction of the non-volatile memory. However, although it is not shown in Fig. 2, because the microcomputer which is to be fixed near the non-volatile memory chip and its peripheral circuit elements are fabricated as discrete electronic parts, the problem remains that most of the size reduction is not achieved, if the printed board on which the non-volatile memory is mounted is viewed as a system. In addition, in the non-volatile memory having the structure illustrated in Fig. 2, rewriting program data onto the non-volatile memory chip must be performed after the program data has been erased by exposing the printed board to ultraviolet light, by touching a write-in terminal, such as a probe or the like, to the conductive pattern extending from the non-volatile memory chip. For this reason, usual conventional ROM writers cannot be used. This entails a troublesome problem in rewriting onto the non-volatile memory.

With the non-volatile memory mounting structure shown in Fig. 1, the non-volatile memory is detachably mounted on the main printed board, so that a usual ROM writer can be used for writing. However, in the same manner as with the mounting structure shown in Fig. 2, the circuits around the non-volatile memory, specifically, the microcomputer and its peripheral circuit elements, such as LSIs, ICs, and the like, are constructed as discreet electronic parts in the same manner as in Fig. 2. This causes the printed board as well as the total system to be large in size, making it impossible to provide a small and light integrated circuit as the user requires. This is a major problem. In addition, an independent printed board for the non-volatile memory is required, and the wiring pattern for connecting the non-volatile memory to a microcomputer becomes very long, bringing about the problem of insufficient size reduction.

With the non-volatile memory mounting structures shown in Fig. 1 and Fig. 2, the complete system becomes large, as outlined above. In addition, because the conductive pattern which connects the non-volatile memory and the peripheral circuit elements are exposed, reliability is lowered.

Furthermore, with the non-volatile memory mounting structures shown in Fig. 1 and Fig. 2, because the non-volatile memory and its peripheral microcomputer and circuit elements, such as LSIs, ICs, and the like are exposed, irregularities are formed on the upper surface of the substrate, reducing operability and making servicing difficult.

D.B. Whitney, Electronic Packaging & Production Vol. 28, No. 6, June 1988, pages 80-81 describes a hybrid integrated circuit device comprising a box-shaped casing in which a hole is formed in a specified position;
a chip-formed microcomputer and its peripheral circuit elements which are positioned in a sealed space formed by the casing;
a non-volatile memory chip positioned in a space enclosed by the hole; and an integrated circuit substrate provided with external leads routed on its peripheries:
wherein electrodes of the microcomputer and the peripheral circuit elements are interconnected through conductive paths formed on the integrated circuit substrate;
and the electrodes of the microcomputer and non-volatile memory chip which feeds data to the microcomputer are not directly connected to external leads inside the casing.

### SUMMARY OF THE INVENTION

Accordingly, a first object of the present invention is to provide a hybrid integrated circuit device which comprises a built-in microcomputer and non-volatile memory which feeds data to the microcomputer, and which functions as an independent electric device by itself.

A second object of the present invention is to provide a hybrid integrated circuit device provided with a built-in non-volatile memory whereby data in the built-in non-volatile memory can easily be rewritten according to various specifications or modifications requested by clients.

A third object of the present invention is to provide a hybrid integrated circuit device with a compact and simple form, which can be dealt with as a unit of electric device as a whole.

A fourth object of the present invention is to provide a hybrid integrated circuit device characterized in that its peripheral printed wiring board can be diminished or omitted.

A fifth object of the present invention is to provide a hybrid integrated circuit device comprising a non-volatile memory whereby data in the non-volatile memory can easily be erased or omitted and built-in circuit elements which are perfectly sealed.

A sixth object of the present invention is to provide a hybrid integrated circuit device comprising a non-volatile memory which can be positioned at an optional place, and an integrated circuit substrate of which the layout can be designed with great ease.

A seventh object of the present invention is to provide a hybrid integrated circuit device provided with a bus line with narrow area which is required to rewrite data in a nonvolatile memory.

An eighth object of the present invention is to provide a hybrid integrated circuit device provided with external leads which is reduced in number for rewriting data in a non-volatile memory.

The present invention is also directed to a structure of an integrated circuit substrate which has good thermal characteristics and high mounting density.

These objects of the present invention are achieved by the hybrid integrated circuit devices of claims 1, 6 and 7.

By means of these devices an area occupied by the conductive paths is reduced, improving mounting efficiency, only by respectively arranging each position of the microcomputer and the non-volatile memory with respect to each external lead. In addition, because it is unnecessary to concern with the positional relationship between the microcomputer and the non-volatile memory, the layout of the integrated circuit substrate can easily be designed.

The second embodiment of the present invention in accordance with claim 6 is more effective than the first embodiment of the present invention in accordance with claim 1. Specifically, the external leads connected to the microcomputer can be reduced, resulting in reducing the external leads of the hybrid integrated circuit device, and a provision for the external circuits can also be reduced because it is unnecessary to interconnect the microcomputer with the non-volatile memory outside the hybrid integrated circuit device. The degree of reduction in numbers of the external leads is remarkable in a modified embodiment which is provided with a two-way serial/parallel conversion circuit between the external lead for the non-volatile memory and the external lead for the gate which selectively connect the electrode of the non-volatile memory. In the modified embodiment, even if the microcomputer and the non-volatile memory are placed in any respective position, the area occupied by the conducting paths which connect the gate to the external leads is small, improving mounting efficiency and facilitating layout design.

By means of the embodiment in accordance with claim 7, external leads to be provided in the hybrid integrated circuit device are almost only those necessary for essential operations, e.g. apparatus control. In particular, the number of the external leads for writing and reading of the non-volatile memory can extremely be reduced by means of a modification of the present invention, in which a logical code which is not expected in an ordinary operation mode is detected and the mode of the hybrid integrated circuit device can automatically be changed to a writing mode for the non-volatile memory according to the logical code.

As mentioned above, high density mounting can be achieved in the hybrid integrated circuit device of this invention, because chip elements are mounted on the integrated circuit substrate. Also, high density mounting without limitation by heat generation is possible because of using, as a integrated circuit substrate material, an aluminum which has a high degree of heat dissipation capacity. Furthermore, the non-volatile memory can arbitrarily be positioned on the integrated circuit substrate because the shape of the casing has no affection on the position of the non-volatile memory. For the non-volatile memory mounted in this way, erasure and rewriting of data can be carried out with great ease.

The features of the present invention are now explained in more detail.

First, the hybrid integrated circuit device of the present invention has the advantage of being able to readily design a layout of a data bus, etc., because it is not necessary to consider the positional relationship of a microcomputer and an EPROM. This is because the microcomputer and the EPROM are not interconnected inside a hybrid integrated circuit device, but each of them are independently led out of the hybrid integrated circuit device. Further, the microcomputer and the EPROM can independently be positioned to minimize the length of buses which are led out of the microcomputer and the EPROM. Loss of mounting density due to the routing of the data buses can be minimized.

Second, the necessity for a conventional printed board is abolished because the area occupied by circuit elements is reduced owing to using chip parts including an EPROM and the mounting density of an integrated circuit substrate is improved.

Third, after a hybrid integrated circuit device is fabricated using an EPROM in which data has not been written, writing of data can be achieved only by means of electrical operations. This means that a specification of the hybrid integrated circuit device can be determined just before the device is forwarded to a customer. The problem of unacceptable processes due to change in the specification can be eliminated.

Fourth, because a metal substrate is used as an integrated circuit substrate, an improvement in heat dissipation effect and an improved degree of integration can be expected. In addition, since conductive paths are formed of copper foil, the resistance of the conductive paths compared with that of conductive paths which are made of a conductive paste is greatly reduced. The equivalent or more extended circuits than those of a printed board can be mounted.

Fifth, by having the peripheral ends of a casing and of an integrated circuit substrate essentially correspond, almost the entire surface of the integrated circuit substrate can be utilized as a sealed space so that an extremely compact hybrid integrated circuit device can be attained along with improved mounting density.

Sixth, an EPROM or a microcomputer with a built-in EPROM can be shielded and protected from light because the upper surface of the EPROM or the microcomputer with a built-in EPROM is covered with a resin and/or a shielding material.

Seventh, a hybrid integrated circuit substrate provided with many pins can be realized, since external lead terminals are led out of one side or both sides in opposition of an integrated circuit substrate.

Other objects, features and advantages of the invention will hereinafter become more readily apparent from the following description.

### BRIEF DESCRIPTION OF THE DRAWINGS

Fig. 1 and Fig. 2 are perspective drawings for explaining mounting structures of a conventional non-volatile memory.

Fig. 3 is a perspective drawing of a first embodiment of the present invention.

Fig. 4 is a sectional drawing viewed along the section I - I in Fig. 3.

Fig. 5 is a drawing for explaining a mounting structure of the integrated circuit substrate used in the present invention. This is a sectional drawing of an integrated circuit substrate which is not yet finished.

Fig. 6 is a sectional drawing viewed along the section I - I in Fig. 3 for explaining other sealed structure of the non-volatile memory.

Fig. 7 is a block diagram of the first embodiment of the present invention.

Fig. 8 is a drawing for explaining writing of data in the non-volatile memory by means of a ROM WRITER.

Fig. 9 is a block diagram showing the first embodiment of the present invention using a microcomputer with a built-in non-volatile memory.

Fig. 10 is a block diagram showing the first embodiment of the present invention using a MODEM.

Fig. 11 and Fig. 12 are respectively block diagrams of an interface used for the MODEM and the microcomputer used.

Fig. 13 is a plan drawing of the integrated circuit substrate used in the first embodiment using the MODEM.

Fig. 14 and Fig. 15 are respectively a perspective drawing and a block diagram showing a second embodiment of the present invention.

Fig. 16 is a block diagram showing the second embodiment using a MODEM.

Fig. 17 is a plan drawing of an integrated circuit substrate showing the second embodiment using the MODEM.

Fig. 18 is a block diagram showing the second embodiment using a microcomputer with a built-in non-volatile memory.

Fig. 19 is a plan drawing of an integrated circuit substrate used in a modification of the second embodiment.

Fig. 20 is a plan drawing of the integrated circuit substrate used in a modification of the second embodiment using the MODEM.

Fig. 21 and Fig. 22 are respectively a perspective drawing and a block diagram showing a third embodiment of the present invention.

Fig. 23 is a plan drawing of an integrated circuit substrate used in the third embodiment using a MODEM.

Fig. 24 is a block diagram showing the third embodiment using a microcomputer with a built-in non-volatile memory.

Fig. 25 is a block diagram showing a modification of the third embodiment.

### DETAILED DESCRIPTION OF THE INVENTION AND PREFERRED EMBODIMENTS

The embodiments of the present invention as well as their modifications are hereinafter illustrated referring to the drawings.

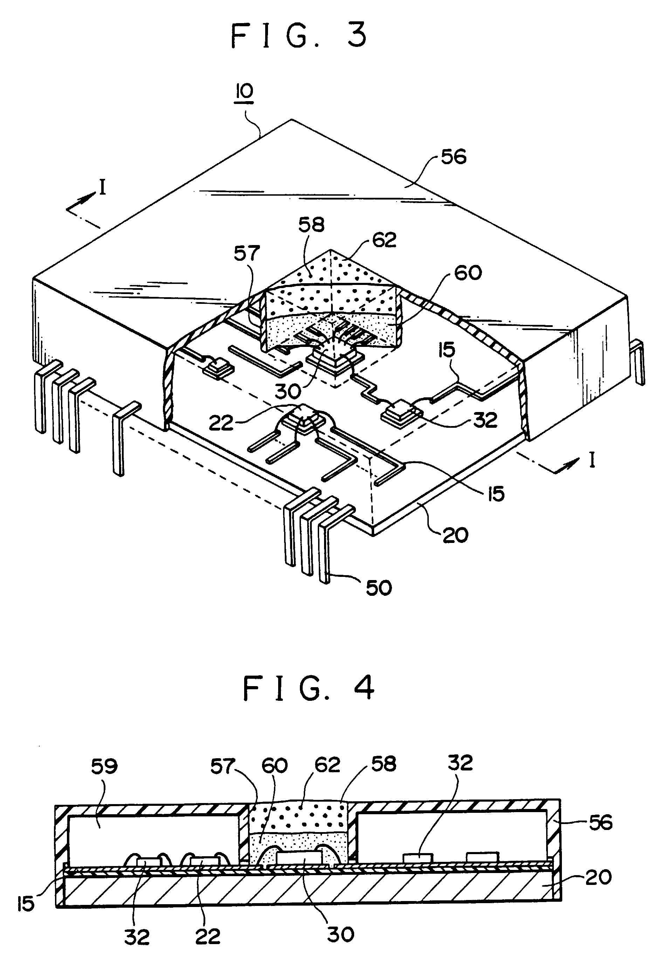

Fig. 3 is a perspective drawing showing the first embodiment. A part of the drawing is sectioned to show the internal structure of the integrated circuit device. The hybrid integrated circuit device 10 of the present invention is provided with: a chip-formed microcomputer 22 and its peripheral circuit elements 32; a non-volatile memory chip 30; an integrated circuit substrate 20 provided with external leads 50 which is secured on pads (omitted from the drawing) continuously formed on conductive paths 15 of the integrated circuit substrate 20; a box-shaped casing 56 in which a hole wall 57 is formed in a specified position; and a first resin layer 60 and a second resin layer 62 which are filled in a space 58 enclosed by the hole wall 57.

The chip-formed microcomputer 22, the non-volatile memory chip 30 which feeds data to the microcomputer 22, and the peripheral circuit elements 32 of the microcomputer 22 are secured to the integrated circuit substrate 20 with a plastic material such as paste, e.g. Ag paste. The electrodes of these chips and elements are wire-bonded to the end of each conductive path 15 which extends close to each electrode.

As shown in Fig. 4 which is a sectional drawing viewed along the section I - I in Fig. 3, the microcomputer 22 and its peripheral circuit elements 32 are positioned in a sealed space 59 formed by the integrated circuit substrate 20, the casing 56, and the hole wall 57; and secured to the integrated circuit substrate 20. The top of the non-volatile memory chip 30 is sealed by the first resin layer 60 and the second resin layer 62. The integrated circuit substrate 20 is also provided with carbon resistors formed by screen printing using a resistant carbon material and nickel resistors prepared by nickeling between each conductive path 15 (both resistors are not shown in the drawings).

Parts materials used in this embodiment and common parts materials used in all embodiments of the present invention are separately illustrated by the following description.

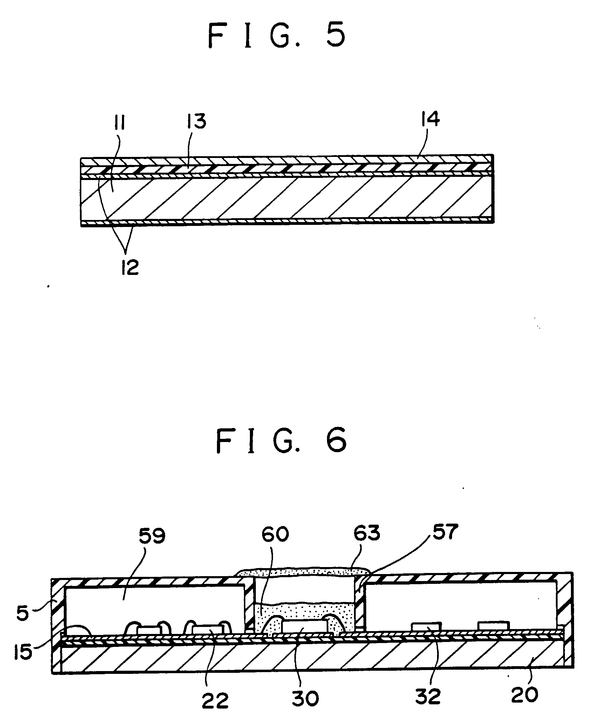

Fig. 5 is a sectional drawing of the incomplete integrated circuit substrate 20. An aluminum substrate 11 of 0.5 mm to 1.0 mm thick is provided with an oxidized aluminum film 12 (alumite layer) on its surface, formed by means of a commonly known anodic oxidation process. Any hard substrate, such as a ceramic, glass-epoxy, or metal substrate may be used in place of the aluminum substrate 11. However, in consideration of its heat dissipation capacity, mechanical strength, workability and the like, an aluminum substrate is most suitable. An insulating resin layer 13 of epoxide, polyimide, or the like, 10 µm to 70 µm thick and a copper foil 14, 10 µm to 70 µm thick, which were integrated previously, are affixed to one main side of the aluminum substrate 11 by a means such as a roller or hot pressing means or the like. The substrate shown in the drawing is prepared in this way.

Next, in order to expose specified conductive paths, a resist film is formed on the surface of the copper foil 14 on the multi-layered substrate and treated by means of a screen-printing method to mask the portions of the resist film other than specified conductive paths, followed by applying a noble metal (gold, silver, platinum) coating. After the removal of the resist film the integrated circuit substrate 11, on which the specified conductive paths 15 are formed, is obtained by etching the copper foil 14 using the noble metal coating layer as a mask. The pattern boundary of the conductive paths 15 from the screen printing process is 0.5 mm, but it is possible to form an extremely fine conductive path 15 with a 5 µm rule by using commonly known photolithography.

As previously mentioned, the chip-formed microcomputer 22 and its peripheral circuit elements 32, and the non-volatile memory chip 30 are secured to the circuit substrate on which the conductive paths 15 are formed. In addition, their electrodes are respectively wire-bonded to the end of the specified conductive paths 15. Modifications of the integrated circuit substrate 20 having the above structure are prepared by changing the pattern of the conductive paths 15 and/or by adding or changing a part of the circuit elements. These modifications are commonly used in the embodiments of the present invention and the modifications of the embodiments.

As will be clear by the consecutive description one by one, in the hybrid integrated circuit device of the present invention, the electrodes of the microcomputer 22 are not interconnected directly with the specified electrode of the non-volatile memory chip 30 on the integrated circuit substrate 20. Particularly, in this embodiment, the microcomputer 22 and the non-volatile chip 30 are independently led out to the peripheries of the integrated circuit substrate 20 through each conductive path 15 and connected to each external lead 50. When performing actual operations in the hybrid integrated circuit device 10 of the present invention, the required external lead terminals are mutually connected outside the hybrid integrated circuit device 10 to carry out regular operation, e.g. essential control. In order to clarify the use of external leads 50, a respective number is hereinafter given to each external lead as follows: the external leads connected only with the microcomputer 22 are referred to as "external lead 51 for the microcomputer"; the external leads connected only with the non-volatile memory chip 30, "external lead 52 for a non-volatile memory"; and the external leads connected only with the peripheral circuit elements 32, "general-purpose external lead 53".

By means of this embodiment provided with the integrated circuit substrate having the above structure, the positions of the microcomputer 22 and the non-volatile memory 28 can be arbitrarily selected, improving mounting efficiency and facilitating a pattern design.

An UVEPROM chip (Ultra Violet Erasable Programmable Read Only Memory), from which data can be erased by ultraviolet light, is used for the non-volatile memory chip 30, (hereinafter, UVEPROM chip is referred to as "EPROM" and the expression "non-volatile memory" is changed to "EPROM"). Since EPROM chips having any form can be used in this invention, detailed explanation about the EPROM chips is omitted.

Again referring to Fig. 3, the casing 56 is formed from an insulating thermoplastic resin in the shape of a box. The peripheral end sections of the box-shaped casing 56 are positioned on the peripheral end sections of the integrated circuit substrate 20. The hole wall 57 is provided in the casing with a size sufficient to expose the EPROM 30 and the bonding wires which connect the EPROM 30 with the conductive paths 15. The perimeter of the casing 56 is firmly secured to the perimeter of the integrated circuit substrate 20 in an integrated manner using a seal material (J-Sheet: trademark) with adhesive characteristics. By these means, the sealed space 59 is formed between the integrated circuit substrate 20 and the casing 56, and the microcomputer 22 and its peripheral circuit elements 32 are positioned in the sealed space 59. The EPROM 30 is positioned in the space 58 enclosed by the hole wall 57 in the casing 56.

The first resin layer 60 which directly covers the EPROM 30 is formed in the space 58 by filling a UV light-transmitting resin. Data on the EPROM 30 can be erased through the first resin layer 60 by ultraviolet light. Any non-aromatic-type resin, for example, a methyl-type silicon rubber or silicon gel, can be used as a UV light-transmitting resin. The EPROM 30 is perfectly covered with the UV light-transmitting resin layer 60. The second resin layer 62 which is used for protecting the data of the EPROM and made from non-UV light transmitting resin is filled onto the first resin layer 60 until its surface corresponds with the top of the casing 56. As the non-UV light transmitting resin, resins having aromatic ring (benzene ring) can be used. For example, an epoxy resin or polyimide resin which contains an aromatic ring (benzene ring) is used. Alternatively, the same effect can be obtained by using seal material 63 for shielding light and by attaching it to the top space section of the hole 58. The casing 56, and the UV light transmitting resin layer 60 and the non-UV light transmitting layer 62 or the seal material 63 which are formed in the hole space 58, are commonly used in all embodiments and their modifications of the present invention.

With this embodiment of the structure outlined above, to erase the data in the EPROM, the UV light transmitting resin layer 62 or the seal material 63 is peeled off and ultraviolet light generated by a UV light generator called as "EPROM erasure" is irradiated onto the EPROM 30 for about 30 minutes. After this UV light irradiation is completed, all data on EPROM falls into "H" level.

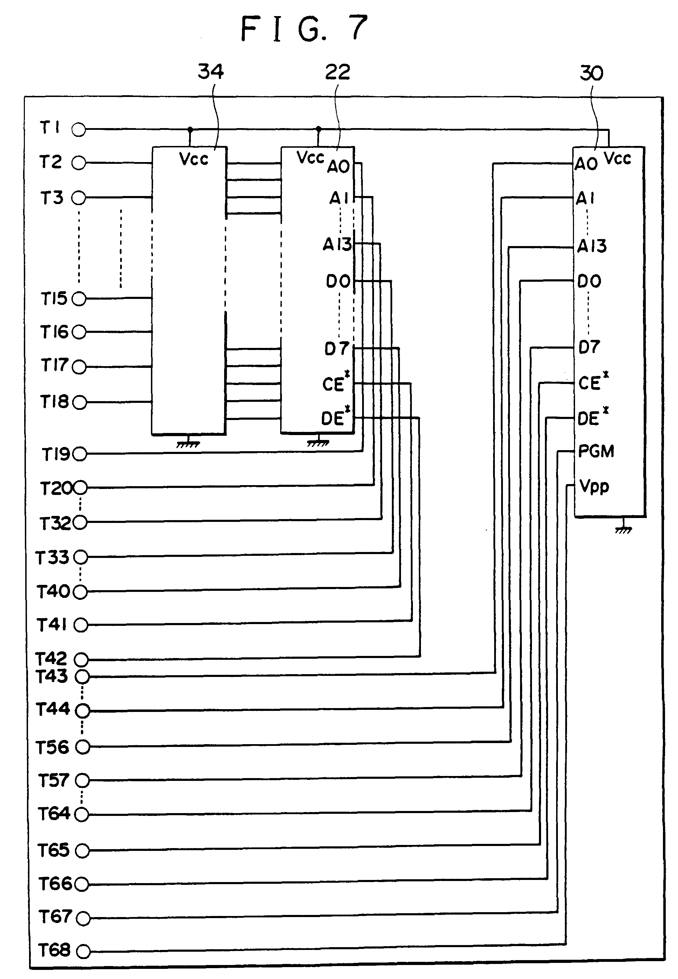

Referring to Fig. 7 which is the block diagram of the hybrid integrated circuit device 10 of the present invention, the first embodiment is illustrated in more detail.

T1 - T18, T19 - T42, and T43 - T68 in Fig. 7 denote each terminal group connected to the general-purpose external lead 53, the external lead 51 for the microcomputer, and the external lead 52 for the EPROM respectively. Reference No. 22 denotes the microcomputer 22. The peripheral circuit elements 32 are denoted by peripheral circuit element block 34.

As an example, a 128K bit EPROM 30 is shown in the drawing. The 128K bit EPROM 30 is provided with fourteen address electrodes A0 - A13, eight data electrodes D0 - D7, and six control or power electrodes CE*, DE*, PGM, V_{cc,} Vₚₚ, and GND. In this embodiment, the address electrodes A0 - A13, eight data electrodes D0 - D7, and six control or power electrodes CE*, DE*, PGM, Vcc, Vₚₚ, and GND, are respectively connected to each terminal group T43 - T56, T57 T64, and T65 - T68 through each independent conductive path. Also, fourteen address electrodes A0 - A13, eight data terminals D0 - D7, and two control electrodes CE*, and DE*, all provided for the microcomputer 22, are respectively connected to each terminal T19 - T42 by each independent conductive path. As shown in the drawing, the electrodes of the microcomputer 22 are not connected to the electrodes of the EPROM 30 inside the hybrid integrated circuit device 10. Each electrode is led out to the periphery of the integrated circuit substrate 20 and connected to each external lead. Here, the terminal T1 is a power terminal from which, for example, V_{cc} of +5V is fed to the peripheral circuit element block 34, the microcomputer 22, and the EPROM 30.

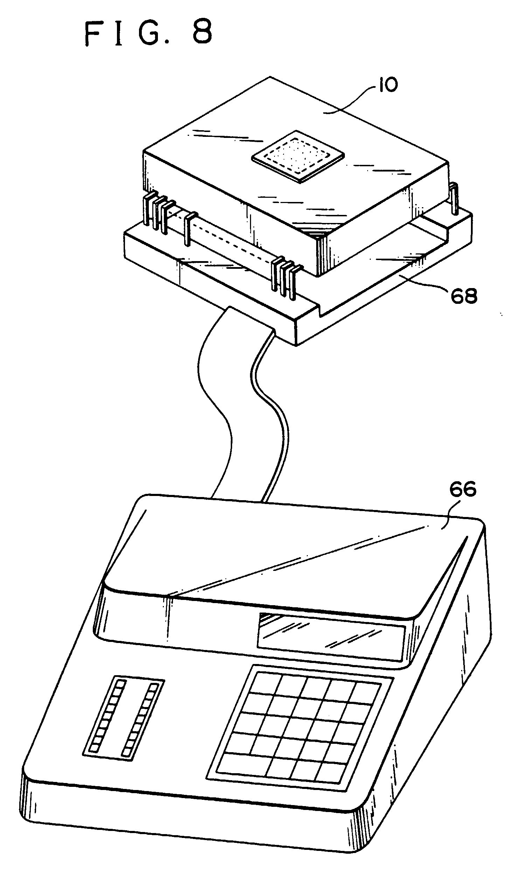

When such a large capacity EPROM as that utilized in the present invention is used, a ROM WRITER which cooperates with a host computer used for developing programs is used to rewrite data in the EPROM. Rewriting of data in an EPROM element is carried out immediately after the EPROM element has been inserted into the EPROM element socket provided in the ROM WRITER. When the rewriting of data in the built-in EPROM 30 of the hybrid integrated circuit device 10 is carried out, it is required to connect the expanded bus of a ROM WRITER 66 with a socket 68 for the hybrid integrated circuit device 10 as shown in Fig. 8. When 26 terminals of the ROM WRITER 66 consisting of fourteen address terminals A0 - A13; eight data terminals D0 - D7; three control signal terminals CE*, OE*, and PGM; and a power terminal of 21V, are respectively connected to a corresponding terminal of the external leads 52 for the EPROM of the hybrid integrated circuit device 10, the electrical condition of the connection between the ROM WRITER 66 and hybrid integrated circuit device 10 is equivalent to an electrical condition at a time when data is written in a single EPROM element using the ROM WRITER 66.

The process of writing data automatically by the ROM WRITER 66 will be explained. It is premised that data has been transferred to an internal memory of the ROM WRITER 66 from a host computer (omitted from the drawing).
(a) It is confirmed whether erasure of all memory cells is completed or not, keeping the EPROM 30 in a read mode (keeping the PGM terminal at a LOW level, OE* and CE* are turned into an ACTIVE LOW level and address data is input into A0 - A13). If non-erased memory cells exist, the ROM WRITER 66 produces a warning sound and does not enter the next writing step.
(b) Writing of data in the addresses of the EPROM 30 is started from a younger address (OE*; HIGH level, CE*; LOW level). While impressing the address A0 - A13 and data D0 - D7 from the ROM WRITER 66 to the EPROM 30, a PGM pulse of 1 msec length is impressed once to the EPROM 30 to write data in the EPROM 30.
(c) Using the same address as in step (b), the EPROM 30 is turned into a read mode (the same condition as in step (a)) and the data which has been written in step (b) is read to compare read-out data with the data written in step (b).

If the read-out data is different from the written data, the operation of (b) step is again carried out using the same address and data as before and (c) step as well. When the read-out data is identical with the written data, the rewriting operation of (b) step is automatically repeated several times in order to ensure a margin for data integrity and reliability improvement. In this way, the rewriting of data for one address is completed.

(d) Using an address added one count to the old address, the rewriting of the data is again repeated from the step (b). The operations of steps (b)-(d) are automatically processed by the ROM WRITER. When it is confirmed that the rewriting of all address data of the EPROM 30 is completed, the operation of the EPROM 30 comes to a stop.

New or renewed data can be written in the EPROM 30 of the hybrid integrated circuit device 10 through these processes.

The capability and function of contemporary computers are remarkably improved. For example, microcomputers with a large capacity built-in EPROM are commercially available. The present invention can be applied to such a microcomputer with a built-in EPROM.

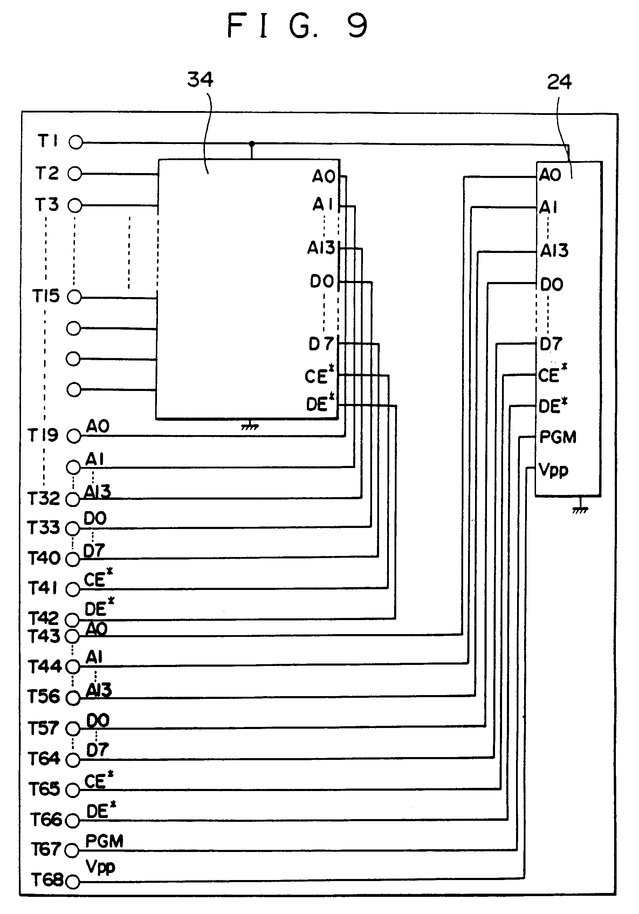

Fig. 9 is a block diagram showing a modification using a microcomputer with a built-in EPROM. In Fig. 9, the same reference numbers corresponding to those used in Fig. 7 are used except for using reference No. 24 for the microcomputer with a built-in EPROM. As a matter of course, in this modification, the microcomputer 24 with a built-in EPROM is positioned in the same place as that of the EPROM 30 in the embodiment which was previously explained.

Here, before explaining the other embodiments of the present invention, in order to improve understanding of the present invention, an explanation will be given of the hybrid integrated circuit device of the present invention which was applied in a MODEM for data transmission via telephone circuits from the data terminal of a computer system or the like.

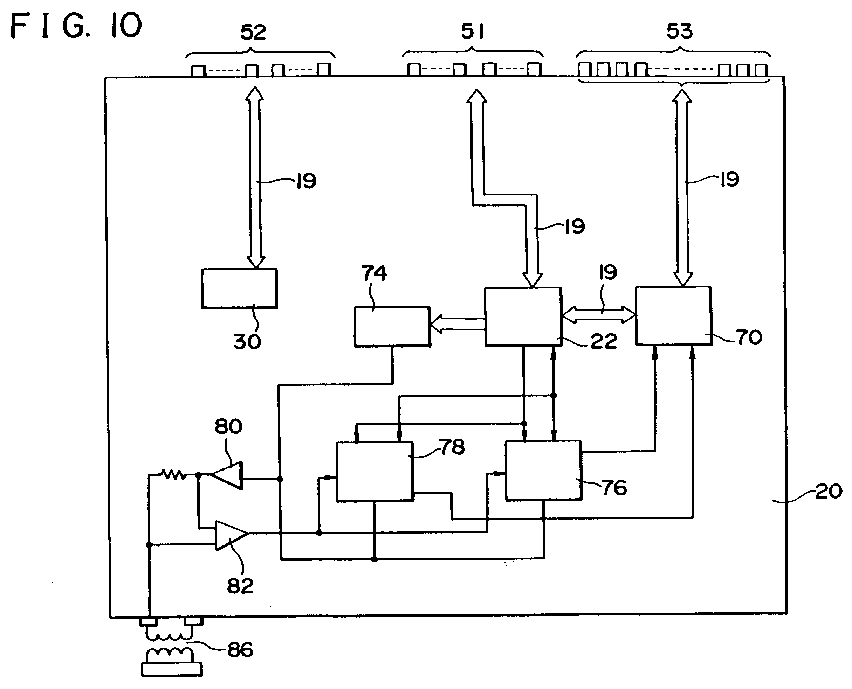

Now referring to Fig. 10, which shows a block diagram with the MODEM mounted on an integrated circuit substrate 20, the MODEM comprises a DTE interface 70 which stores, in its built-in memory, data transmitted from a computer system and outputs the data; a microcomputer 22 which outputs a specified output signal according to the data output from the DTE interface 70; an EPROM 30 which is accessed from the microcomputer 22; a pair of (first and second) modulator-demodulator circuits 74, 76 which modulate and demodulate the output signals from the microcomputer 22 and output them to an NCU (Network Control Unit System, omitted from the drawings); and a DTMF generator 78 which generates a desired DTMF signal (tone signal) corresponding to the output signal from the microcomputer 22.

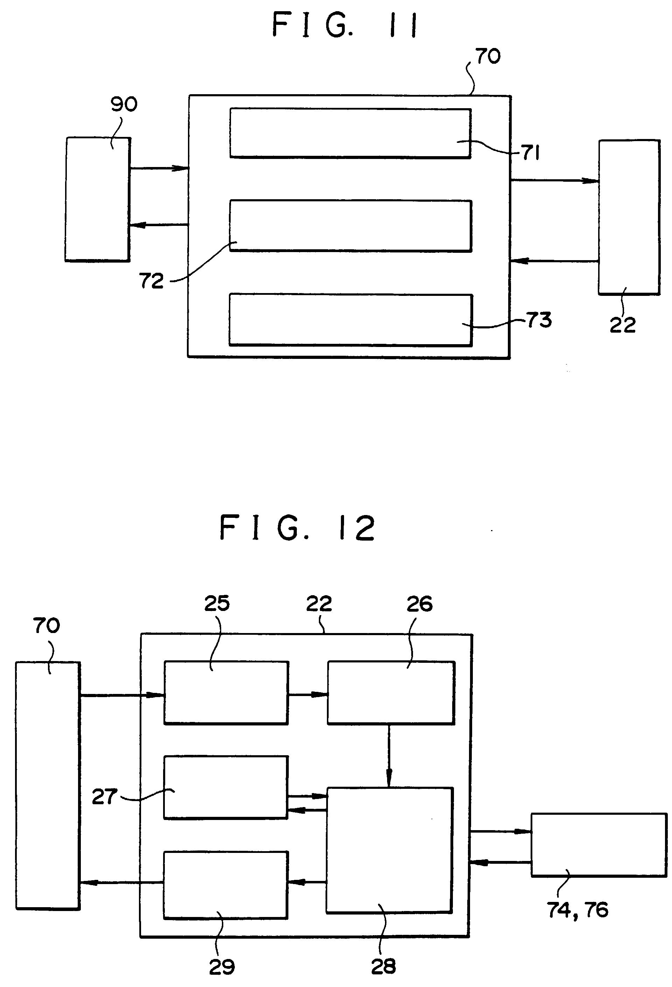

An integrated circuit such as, for example, an STC9610 (manufactured by Seiko-Epson) is used for the DTE interface 70. Now referring to Fig. 11 which is a block diagram of this type of DTE interface 70, the DTE interface 70 comprises a transmission memory section 71 which temporarily stores the output signal from the computer system 90 in its built-in memory and outputs it to the microcomputer 22; a reception memory section 72 which stores the output signal from the microcomputer 22 in its built-in memory and outputs it to the computer system 90; and a control section 73 which switches the various input/output signals via the transmission memory section 71 and the reception memory section 72, and has the specific function of connecting the computer system 90 and the microcomputer 22.

An integrated circuit such as, for example, an STC9620 (manufactured by Seiko-Epson) is used for the microcomputer 22. Now referring to Fig. 12 which is a block diagram of the microcomputer 22, the microcomputer 22 comprises a command recognition section 25 for the recognition of signals output from the DTE interface 70; a command decoding section 26 which decodes the output signals recognized by the command recognition section 25; a command execution section 28 which compares the data in the memory section 27 according to the signal decoded in the command decoding section 6 and feeds the data to the modulator-demodulator circuits 74, 76; a response code generation section 29 which compares the data in the command decoding section 26 with the data in the memory section 27 and outputs a signal to the DTE interface 70 when erroneous data is fed to the command execution section 28.

Again referring to Fig. 10, the modulator-demodulator circuits 74, 76 convert a digital signal transmitted from the microcomputer 22 to an analog signal and transmits it to the NCU section (omitted from the drawings), and, conversely, converts an analog signal transmitted from the NCU section to a digital signal and transmits it to the microcomputer 22. The modulator-demodulator circuits 74, 76 are provided with both a low speed circuit and a medium speed circuit. The first modulator-demodulator circuit 74 is a low speed, 300 bps circuit, and the second modulator-demodulator circuit 76 is a medium speed, 1200 bps circuit. The microcomputer 22 selects one of the first or second modulator-demodulator circuits 74, 76. The DTMF generator 78, by inputting the data output from the command execution section of the microcomputer 22 to the respective COL, ROW input terminals, outputs a specific DTMF signal to a transmission AMP 80 to output the signal to telephone circuits.

Program data for setting the various kinds of modes of the MODEM is stored in memory in the EPROM 30. This data is fed to the microcomputer 22 according to an address indicated by the microcomputer 22 through an external lead (omitted from the drawing).

Next, the behavior of a modem will be briefly explained with reference to Fig. 10 and Fig. 11. It is premised that the external leads 51 for the microcomputer are connected with the external leads 52 for the EPROM through specified circuits outside the hybrid integrated circuit device.

On the commencement of data communication, a MODEM is subjected to test according to the following procedures. Specific data is fed to the EPROM 30 according to address signals from the microcomputer 22 and data of the EPROM 30 based on this address data is fed to the microcomputer 22. A check is made to confirm that the various modes, such as the communication standards (Bell/CCITT standards) of the MODEM which carries out the communications, the communication speeds (300/1200 bps), format correspondence, and the DIP switch switching modes are in agreement.

When these modes are in agreement the telephone number of the MODEM of the response side computer system 90 is keyed in and this telephone number is input to the DTE interface 70 used as the interface for the computer system 90. This telephone number is also transmitted to the microcomputer 22 for decoding. The result decoded by the microcomputer 22 is transmitted to the DTMF generator 78. The DTMF signal of the DTMF generator 78 is transmitted to the ordinary telephone circuits through a transmission amplifier 80 and a line transformer 86.

The transmitted DMTF signal sends out a CALL signal to the response side modem. The response side receives and automatically accepts the CALL signal. By the above procedures, the response side modem transmits an answer tone to the call side modem, that is, the hybrid integrated circuit device 10 of the present invention.

The call side modem determines whether or not the answer tone is the specified answer tone to the call side modem. If the correct answer tone has been received this modem enters communication status.

On entering communication status, the call side parallel data according to a specific keyed input signal, through a keyboard (omitted from the drawings) at the call side microcomputer 22 is input to the DTE interface 70. This data is also transmitted to the microcomputer 22. Next, the parallel data is converted to serial data and is transmitted to the low speed modulator-demodulator circuit 74. Here, the digital signal is converted to an analog signal and undergoes frequency modulation (FSK) based on the communication standards, and is transmitted to the response side MODEM via transmission amplifier 80 and the line transformer 86.

The frequency modulated analog signal according to the keyed input signal from the response side computer system 90 is transmitted to the call side MODEM and is input to the low speed modulator-demodulator circuit 74 through the line transformer 86 and a receiving amplifier 82. Here, the analog signal is converted to a digital signal and is input to the DTE interface 70, then the serial digital signal is converted to parallel digital signal in the DTE interface 70 and is input to the call side microcomputer 22. This results in the establishment of full duplex communication between the call side microcomputer 22 and the response side computer system 90.

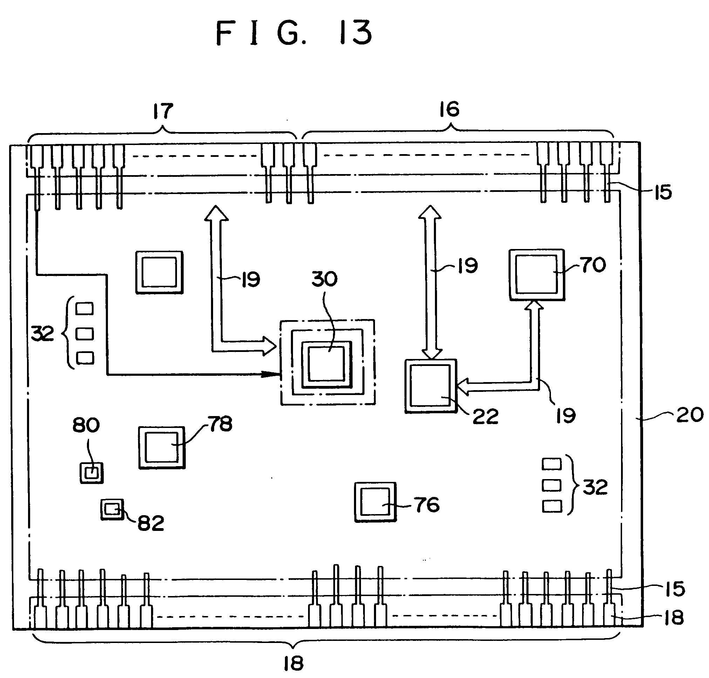

Fig. 13 is a plan drawing of the integrated circuit substrate 20 provided for realizing the MODEM shown in Fig. 10. The reference numbers used for the circuit elements are the same as those used in Fig. 10. To avoid confusion, the conductive paths which connect a plurality of the circuit elements are almost omitted from the drawing, with only a part of them shown by bus lines 19.

As shown in Fig. 13, a plurality of securing pads 16, 17, and 18 are formed on both sides in opposition of the peripheral end section on the integrated circuit substrate 20 to secure external leads 51 for a microcomputer, external leads 52 for an EPROM, and general-purpose external leads 53. Conductive paths 15 are formed connecting with each of the securing pads 16, 17, 18. The microcomputer 22, the DTE interface 70, the first and second modulator-demodulator circuits 74, 76, the DTMF generator circuit 78, chip parts 32, e.g. condensers, and the EPROM 30 which feeds data to the microcomputer 22 are secured to the integrated circuit substrate 20. These elements is interconnected with each other by bus lines 19 constituted of the specified conductive paths 15 except for the connection of the microcomputer 22 and the EPROM 30. By these means and configuration the hybrid integrated circuit device functions as a MODEM. The region enclosed by the dashed line is the region which is secured to the casing 56 using the adhesive sheet.

As shown in Fig. 13, in this embodiment, the microcomputer 22 and the EPROM 30 are arranged in a position adjacent to the external lead 51 for the microcomputer 22 and the external lead 52 for the EPROM 30 respectively. Therefore, the occupied area of the conductive paths 15 to connect each of these elements can be greatly reduced to provide high density mounting. Also, because it is possible to design the position of the microcomputer 22 independently of the EPROM 30, the pattern of the integrated circuit substrate 20 can be designed with great ease.

The hybrid integrated circuit device used for the MODEM described above can cope with various program modifications required by set-makers (users), such as various modifications for destination, various types of dealing, e.g. OEM, in-house sales, and the like. Specifically, when a hybrid integrated circuit device is only designed based on the specifications of a specific user, it will not cope with other user's specifications occasionally. Conventionally, it is necessary to revise the design of the hybrid integrated circuit device. However, with the embodiment of the present invention in which the electrode of a microcomputer is not connected to the electrode of an EPROM inside hybrid integrated circuit device, and wires of each electrode are led out of the hybrid integrated circuit device by each independent conductive path, rewriting in an EPROM chip can be easily carried out. It is therefore possible that the embodiment of this invention satisfies a wide variety of user's specifications.

As shown in the above detailed explanation, first, the present embodiment has the advantage of being able to readily design a layout of a data bus, etc., because it is not necessary to consider the positional relationship of a microcomputer and an EPROM. This is because the microcomputer and the EPROM are not interconnected inside a hybrid integrated circuit device, but each of them are independently led out of the hybrid integrated circuit device. Further, the microcomputer and the EPROM can independently be positioned to minimize the length of buses which are led out of the microcomputer and the EPROM. Loss of mounting density due to the routing of the data buses can be minimized.

Second, the necessity for a conventional printed board is abolished because the area occupied by circuit elements is reduced owing to using chip parts including an EPROM and the mounting density of an integrated circuit substrate is improved.

Third, after a hybrid integrated circuit device is fabricated using an EPROM in which data has not been written, writing of data can be achieved only by means of electrical operations. This means that a specification of the hybrid integrated circuit device can be determined just before the device is forwarded to a customer. The problem of unacceptable processes due to change in the specification can be eliminated.

Fourth, because a metal substrate is used as an integrated circuit substrate, an improvement in heat dissipation effect and an improved degree of integration can be expected. In addition, since conductive paths are formed of copper foil, the resistance of the conductive paths compared with that of conductive paths which are made of a conductive paste is greatly reduced. The equivalent or more extended circuits than those of a printed board can be mounted.

Fifth, by having the peripheral ends of a casing and of an integrated circuit substrate essentially correspond, almost the entire surface of the integrated circuit substrate can be utilized as a sealed space so that an extremely compact hybrid integrated circuit device can be attained along with improved mounting density.

Sixth, an EPROM or a microcomputer with a built-in EPROM can be shielded and protected from light because the upper surface of the EPROM or the microcomputer with a built-in EPROM is covered with a resin and/or a shielding material.

Seventh, a hybrid integrated circuit substrate provided with many pins can be realized, since external lead terminals are led out of one side or both sides in opposition of an integrated circuit substrate.

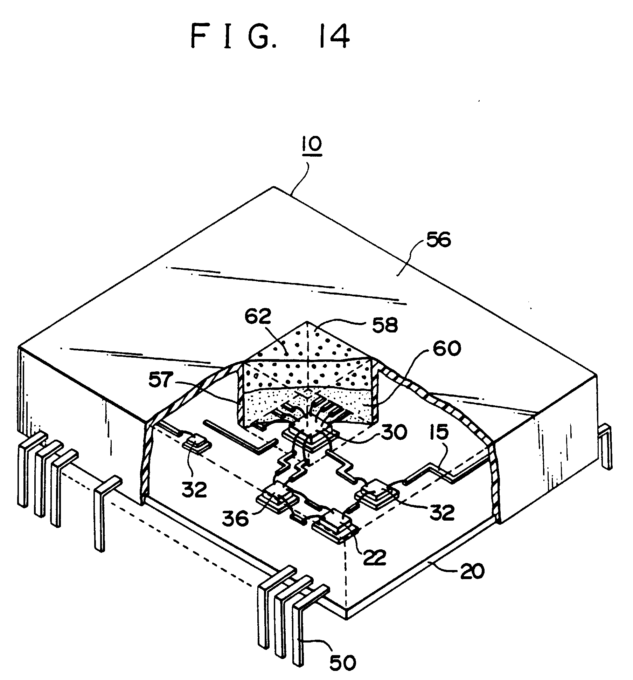

Now referring to Figs. 14-17, the second embodiment of the present invention is explained.

Fig.14 is a perspective drawing of the hybrid integrated circuit device of the second embodiment showing its internal structure in section. The hybrid integrated circuit device 10 is provided with: a chip-formed microcomputer 22, EPROM 30, gate 36, and peripheral circuit elements 32; an integrated circuit substrate 20 provided with a plurality of an external lead 50 which is secured to pads (omitted from the drawing) formed connecting to specified conductive paths 15; a casing 56 provided with a hole wall 57 in the specified position; a UV light-transmitting resin layer 60 which is filled in a space 58 formed by the hole wall 57; and a non-UV light-transmitting resin layer 62.

The external leads 50 in this embodiment are classified in two groups. A first group is used for regular operations such as an essential control operation and the like, and the second group is used only for writing in the EPROM 30. Hereinafter, the first group is referred to as general-purpose external leads 53 and the second group is referred to as EPROM external leads 52.

For the gate 36, a CMOS type multiplexer [MC 14053 (trademark), manufactured by Motorola Co.)] or an ASIC IC, e.g. a CMOS gate array, a standard cell, is used. The gate 36 has a function as a selective connector whereby each electrode of the EPROM 30 is selectively connected to each electrode of the microcomputer 22 or each external lead terminal corresponding to the electrode of the EPROM 30. In order to reduce the area occupied by the conductive paths 15, the gate 36 is positioned between and adjacent to the microcomputer 22 and the EPROM 30. The gate 36 is also positioned adjacent to the EPROM external leads 52.

A 128K bit EPROM, for example, is provided with at least fourteen address electrodes A0 - A13, eight data electrodes D0 - D7, and six control or power electrodes CE*, DE*, PGM, Vₚₚ, V_{cc}, and GND. 26 switches with double-contact per circuit must be provided to connect each of these electrodes with each electrode of the microcomputer 22 or each terminal of the EPROM external leads corresponding to these electrodes. When the multiplexer (MC 14053 manufactured by Motorola Co.) is applied, nine MC 14053s are used as the gate 36 and mounted on the integrated circuit substrate 20. When the ASIC IC, e.g. a CMOS gate, a standard cell is applied, the gate 30 can be constituted of a single chip, providing more small-sized integrated circuit substrate.

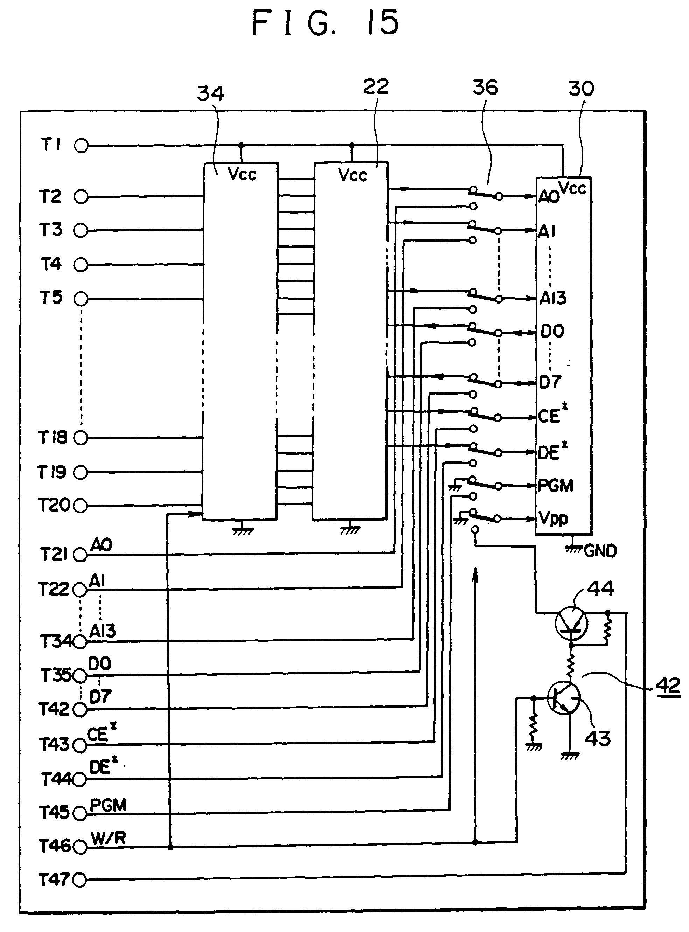

Fig. 15 shows the block diagram of the second embodiment. In the drawing, the terminals T1-T20 are connected to the general-purpose external leads 53, and the terminals T21-T47 are connected to the EPROM external leads 52. Also, in the drawing, the same reference numbers as used in the previous drawing are given for the microcomputer, EPROM, and gate, and the plurality of the peripheral circuit element 32 is shown as the peripheral circuit element block 34.

The hybrid integrated circuit device 10 of this embodiment is provided with two modes which are controlled by a control signal R/W which is fed to the terminal T46. Specifically, if a logic level of the signal R/W is LOW, the gate 36 is controlled by the signal to be in the connection status a shown in the block diagram whereby the electrode of the microcomputer 22 is connected to the corresponding electrode of the EPROM 30. Consequently, the microcomputer 22, the EPROM 30, and the peripheral circuit element block 34 cooperatively work and the system is turned into a regular operation mode whereby an airplane, a car, or the like or communications are controlled. At this time, the erroneous action of the hybrid integrated circuit device 10 is checked by taking a measure of grounding the electrodes PGM and Vₚₚ of the EPROM 30 through the gate 36.

While, if the logic level of the control signal R/W is HIGH, the specified electrodes of the EPROM 30 are broken from each corresponding electrode of the microcomputer by the gate 36 and connected to the terminals T1-T45. At the same time, the control signal R/W is transferred to the peripheral circuit element block 34 whereby the microcomputer 22 is suspended. By the above process, the status of the hybrid integrated circuit device 10 is turned into a data-writing mode whereby the hybrid integrated circuit device 10 can be treated as a single EPROM through terminals T21-T47.

The above control signal R/W is also fed to a power switch 42, which turns on its NPN transistor 43 and PNP transistor 44. A voltage of 21V is fed to the Vₚₚ electrode of the EPROM 30 from the terminal T47 through the power switch 42. Subsequent data-writing procedures are carried out according to the same procedures as in the embodiment previously explained.

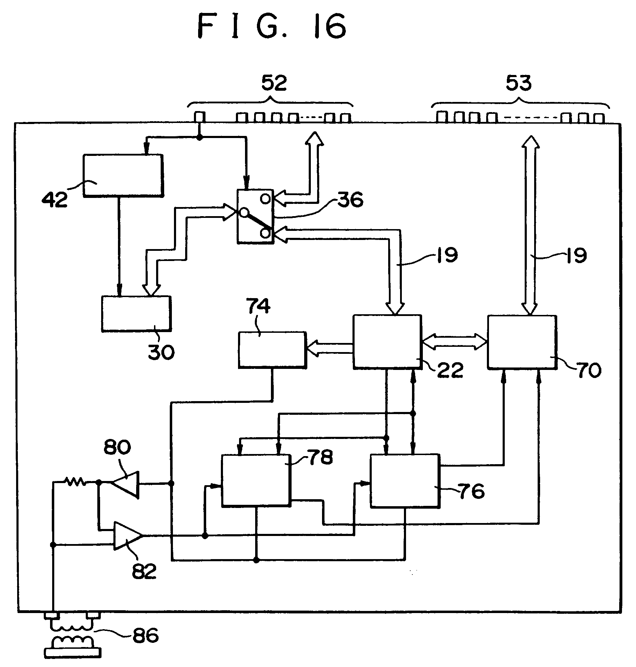

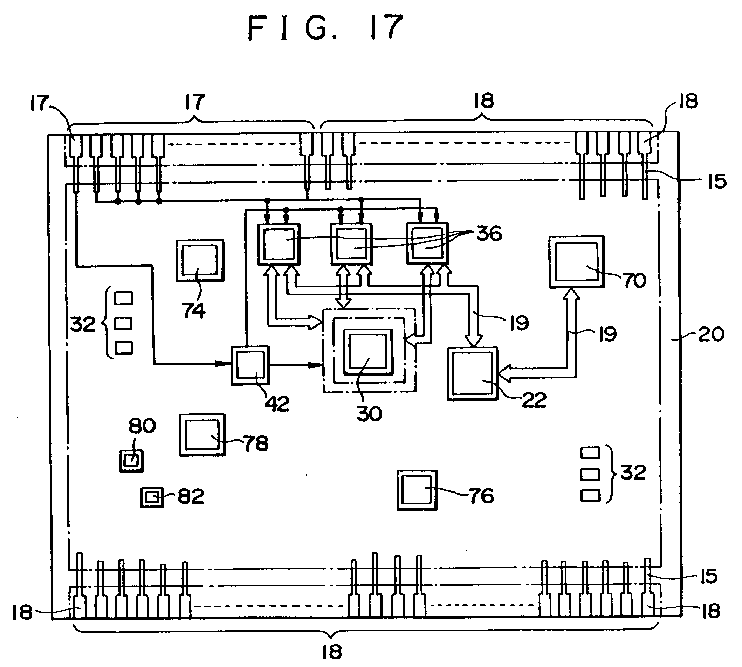

Fig. 16 and Fig. 17 respectively show a block diagram of this embodiment using a MODEM and a plan drawing of the integrated circuit substrate 20 of this embodiment. Here, reference numbers of circuit elements are common in all drawings in the specification, so that detail explanations for Figs. 16 and 17 are omitted.

Now, referring to Fig. 17, it shows the gate 36 which is represented by three chips for the sake of convenience. The gate 36 is positioned adjacent to the microcomputer 22 and the EPROM 30. The gate 36 is also positioned adjacent to the EPROM external lead terminals 41.

The plurality of pads 17, 18 is formed on both sides in opposition of the peripheral end of the integrated circuit substrate 20. The EPROM external leads 52 and the general-purpose external leads 53 (omitted from the drawing) are secured to the pads 17 and 18. The conductive paths 15 are formed connecting with the pads 17 and 18. To the integrated substrate 20 are secured the microcomputer 22; the DTE interface 70; the first and second modulator-demodulator circuits 74, 76; the DTMF generator circuit 78; the chip parts 32, e.g. condensers; and the EPROM 30 which feeds data to the microcomputer 22. An area enclosed by a dashed line is a region secured to the casing 56 by an adhesive sheet.

As is clear in Fig. 6, the microcomputer 22 and the peripheral circuit elements 32, e.g. the DTE interface 70, are always interconnected by the bus lines 19 constituted of the specified conductive paths 15. When the gate 36 is in the connection status as shown in the drawing, the hybrid integrated circuit device 10 of this embodiment functions as a microcomputer with a built-in EPROM through the general-purpose external leads 53 and also functions as the MODEM previously mentioned. When the connection status of the gate 36 is reversed, the hybrid integrated circuit device of this embodiment can be treated as a single EPROM through the EPROM external leads 52. With the second embodiment, an area occupied by the conductive paths 15 is extremely reduced by means of, in particular, placing the gate 36 adjacent to the EPROM 30 and the microcomputer 22, and also to the EPROM external leads 15.

The second embodiment of this invention provided with the above structure has, besides the effect of the first embodiment, an advantage of high mounting efficiency because of there being no necessity for conductive paths between a microcomputer and external leads. The second embodiment also brings about the effect of reducing external leads.

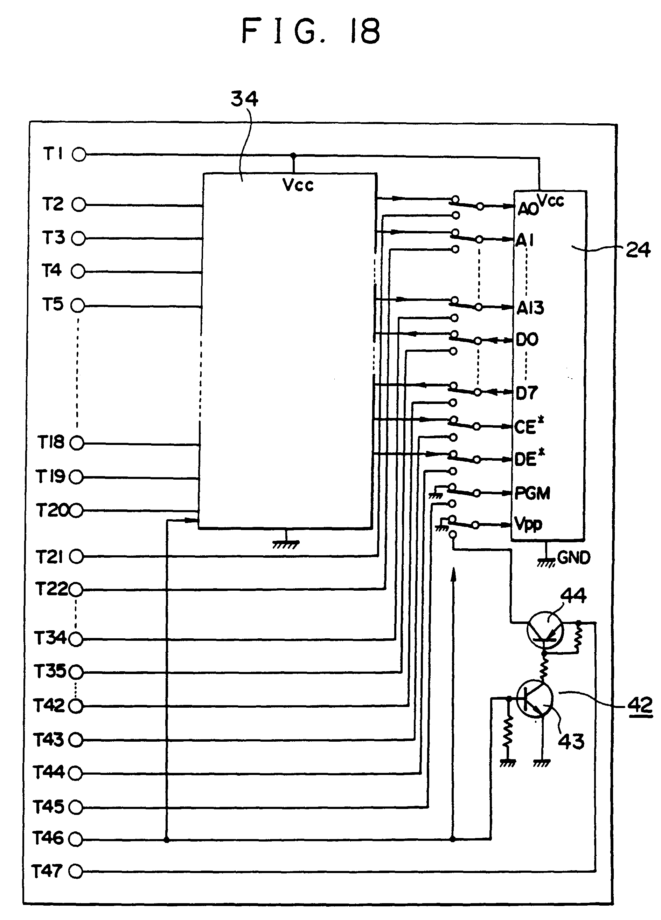

In this embodiment, a microcomputer with a built-in EPROM can also be used. Fig. 18 is a block diagram for explaining the second embodiment using the microcomputer with a built-in EPROM. In the block diagram, the same reference numbers as in Fig. 15 are used except that reference number 24 is used for the microcomputer with a built-in EPROM. In this embodiment, the microcomputer with a built-in EPROM is assembled on the same position as the EPROM 30 in the embodiment previously explained.

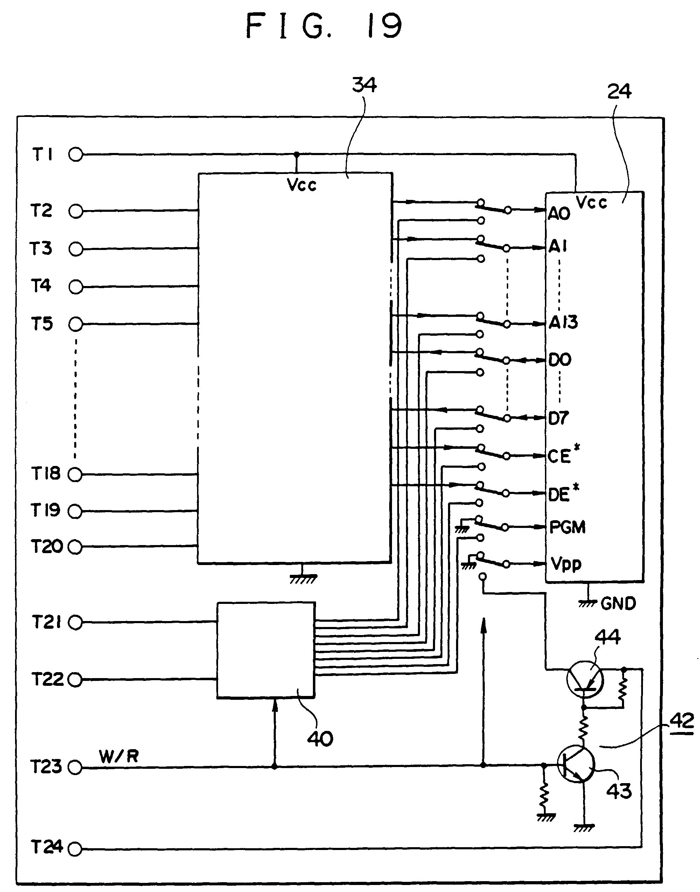

Next, referring to Fig. 19 showing a block diagram, a modification of the second embodiment is explained.

In this block diagram, the terminals T1-T20 are those connected to the general-purpose external leads 53 and the terminals T21-T22 are those connected to the EPROM external leads 52. In this modification, four external leads including the terminals T23 and T24 later-explained are required for writing data in EPROM 30. The same reference numbers as used in the previous diagram are used for a microcomputer, an EPROM, and a gate. Peripheral circuit elements are shown as a peripheral circuit element block 34. A parallel-serial conversion circuit is shown as a reference number 40.

The parallel-serial conversion circuit 40 has a two-way conversion function by which serial data input in the terminal T21 is converted to parallel data, which is fed to the EPROM 30 and parallel data output from the EPROM 30 is converted to serial data which is fed to the terminal T22. In a prototype of this modification, a one-chip microcomputer [8051 (trademark), manufactured by Intel Co.) is used as the parallel-serial conversion circuit 40. However, any parallel-serial conversion circuit including those formed of individual circuit elements and those provided as a family of a microcomputer may be used.

In the modification of this embodiment, the hybrid integrated circuit device 10 is also provided with two modes which are controlled by a control signal R/W which is fed to the terminal T23. Specifically, a first mode is a regular operation mode whereby a microcomputer 22, EPROM 30, and peripheral circuit element block 34 cooperate to control an airplane, car, or the like or communications. A second mode is a reverse mode whereby the running of the microcomputer 22 is suspended and data can be written in the EPROM 30.

If the status of the signal R/W is LOW level, the running of the parallel-serial conversion circuit 4u is suspended and the gate 36 is turned into the connection status as shown in the block diagram whereby the system fall into a regular operation mode. Whereas, if the status of the control signal R/W is HIGH level, the parallel-serial conversion circuit 40 is on and the gate 36 connects the parallel output terminals of the parallel-serial conversion circuit 40 with each corresponding electrode of the EPROM. The above control signal R/W is also fed to a power switch 42, and turns on its NPN transistor 43 and PNP transistor 44 whereby a Vₚₚ of 21V required for writing data fed from the terminal 47 to the EPROM is transferred to the Vₚₚ electrode of the EPROM 30. Subsequent data-writing procedures are carried out according to the same procedures as in the embodiment previously explained except for using a ROM WRITER capable of processing input and output of a serial signal. As for the ROM WRITER, the availability of ROM WRITERs capable of processing input and output of a serial signal must be considered. However, it is easy for a person having an ordinary skill in the art to prepare such ROM WRITERs. It shall not affect on the realizing of this modification of the present invention.

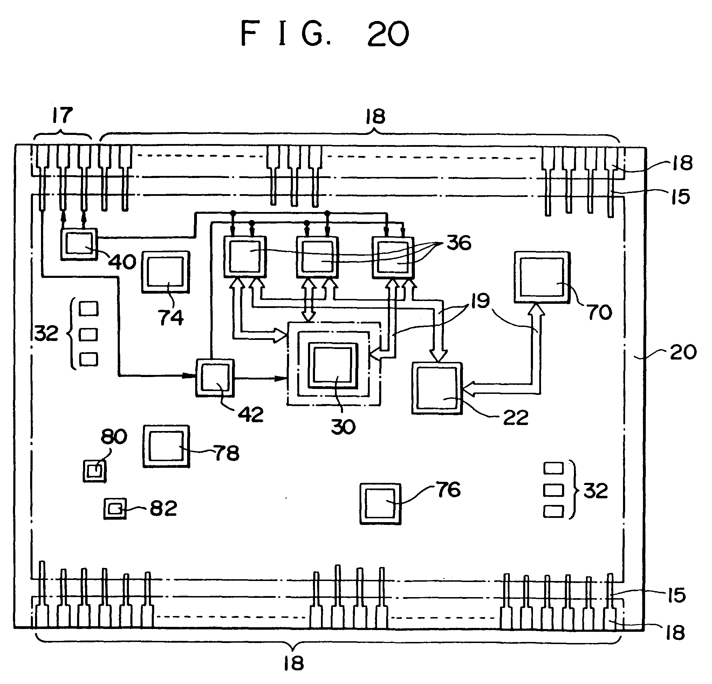

Fig. 20 is a plan drawing of the integrated circuit substrate 20 of this modification mounting a MODEM.

The pads 17 are formed on one peripheral end of the integrated circuit substrate 20 and the pads 18 are formed on the opposite end of the integrated circuit substrate 20. The EPROM external leads 52 are secured to the pads 17 and general-purpose external leads are secured to the pads 18. The conductive paths 15 are formed connecting to the pads 17, 18. Further, to the integrated substrate 20 are secured the microcomputer 22; the DTE interface 70; the first and second modulator-demodulator circuits 74, 76; the DTMF generator circuit 78; the chip parts 32, e.g. condensers; and the EPROM 30 which feeds data to the microcomputer 22; the parallel-serial conversion circuit 40; and the gate 36 which is represented by three chips in the drawing for the sake of convenience.

These elements are interconnected by the bus lines 19 formed of the specified conductive paths 15 except for a connection between the microcomputer 22 and the EPROM 30. By these means, the hybrid integrated circuit device functions as the MODEM previously explained. The modification in which the parallel-serial conversion circuit 40 is connected by a serial bus with the pads 18 to which the EPROM external leads are secured has, besides the effect of the embodiment previously explained, an advantage of reducing external leads, decreasing the area occupied by the conductive paths 15, and improving mounting efficiency, because data-writing in the EPROM 30 can be conducted through the serial bus. If the gate 36 is positioned adjacent to the parallel-serial conversion circuit 40, they can be arbitrarily positioned, facilitating pattern designing of the integrated circuit substrate 20.

In this modification, a microcomputer with a built-in EPROM can also be used.

As illustrated hereinbefore, the hybrid integrated circuit device of the first embodiment is provided with a comparatively large number of external leads including general-purpose external leads, external leads for a microcomputer, and external leads for an EPROM. The hybrid integrated circuit device of the second embodiment is provided with general-purpose external leads and EPROM external leads. The following is an explanation for the: hybrid integrated circuit device of the third embodiment which is provided with a comparatively small number of external leads. In the third embodiment, the hybrid integrated circuit device is provided with a few external leads for change-over of an operation mode and for data-writing and for a power source other than general-purpose external leads.

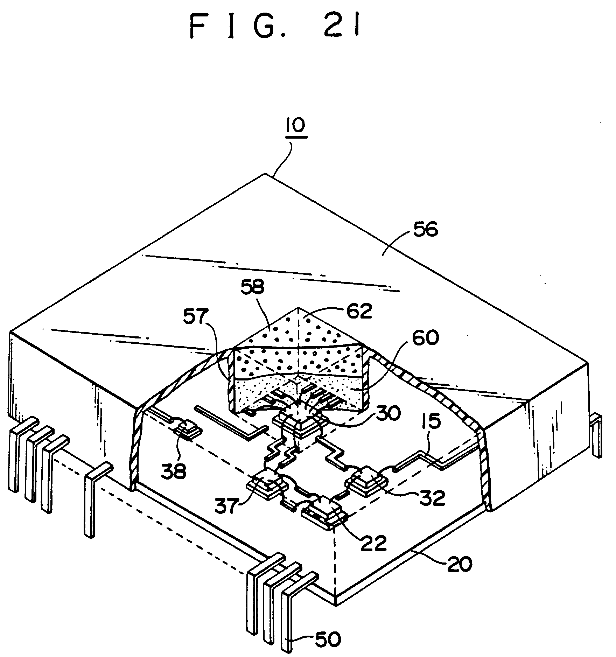

Fig. 21 is a perspective drawing of the hybrid integrated circuit device 10 of the third embodiment showing its internal structure in section. The hybrid integrated circuit device 10 of this embodiment is provided with a chip-formed microcomputer 22 and its peripheral circuit elements 32; a non-volatile memory chip 30; a first and second gates 37, 38; an integrated circuit substrate 20 provided with a plurality of external leads 50 which is secured to pads (omitted from the drawing) formed connecting to specified conductive paths 15; a casing 56 provided with a hole wall 57 in the specified position; and a UV light-transmitting resin layer 60 and a non-UV light-transmitting resin layer 62 which are filled in a space 58 enclosed by the hole wall 57.

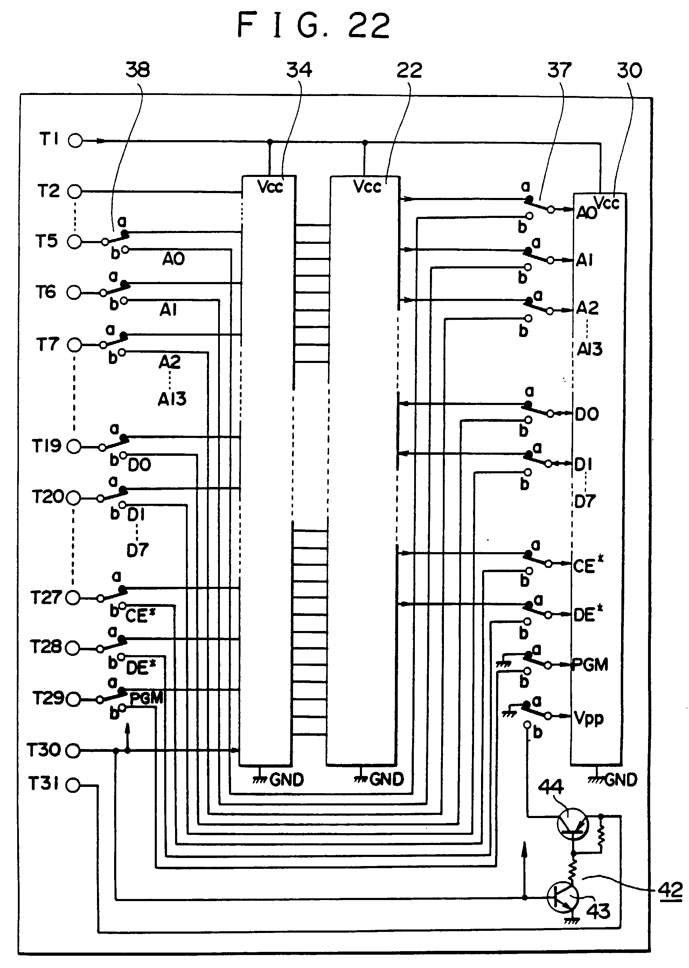

Fig. 22 is a block diagram for explaining the third embodiment. In the drawing, terminals T1-T35 are connected to the external leads 50 of the hybrid integrated circuit device 10. Among these terminals, the terminals T1-T28 are commonly used for the regular operation of the hybrid integrated circuit device and data-writing in the EPROM 30. While, the terminals T29-T31 are used only for data-writing in the EPROM 30. In explanations hereinafter, as required, external leads connected to the terminals T1-T28 are called common external leads 54 and external leads connected to terminals T29-T31, EPROM external leads 54. In the diagram, a plurality of the peripheral circuit elements is represented by a peripheral circuit element block 34.

This embodiment is provided with a first gate 37 and a second gate 38. The first gate 37 selectively connects each electrode of the EPROM 30 with either each corresponding electrode of the microcomputer 22 or b contact of the second gate 38 explained later. The second gate 38 selectively connects each of terminals T5-T29 with either each corresponding terminals of the peripheral circuit element block 36 or b contact of the first gate 37.

As the gates 37, 38, a CMOS-type multiplexer (MC 14053, manufactured by Motorola Co.,) or an ASIC IC such as a CMOS-type gate array, a standard cell, or the like is used. When a 128K bit EPROM 28 is used, seventeen MC 14053 are mounted on the integrated circuit substrate 20 as the gates 37, 38.

The hybrid integrated circuit device 10 of this embodiment is provided with two modes which are controlled by a control signal R/W which is fed to the terminal T30.

Specifically, if the status of the signal R/W is a LOW level, as shown in the diagram, the gate 37 and the gate 38 are both connected to b contact. Then, each terminal of the peripheral circuit element block 34 is connected to each of the common external lead terminals 54 through the terminals T5-T28, and the microcomputer 22 is connected to the specified electrode of the EPROM 30. Consequently, an essential control or similar operation is carried out by the hybrid integrated circuit device 10. At this time, the electrode PGM and the Vₚₚ of the EPROM 30 are grounded through the first gate 37 to check erroneous actions.

While, if the status of the control signal R/W is a HIGH level, the first and second gates 37, 38 are both connected to the contact b whereby each terminal of the peripheral circuit element block 34 is broken from each of the terminals T5-T28. At the same time, the peripheral circuit element block 34 and the microcomputer 22 are suspended by the control signal R/W. Each of the specified electrodes of the EPROM 30 is connected to each of the common external leads 54 through the b contact of the first gate 37, the b contact of the second gate 38, and each of the terminals T5-T29. In this mode, electrical condition of the hybrid integrated circuit device 10 is equivalent to that of a single EPROM 30, making it possible to write data using a ROM WRITER.

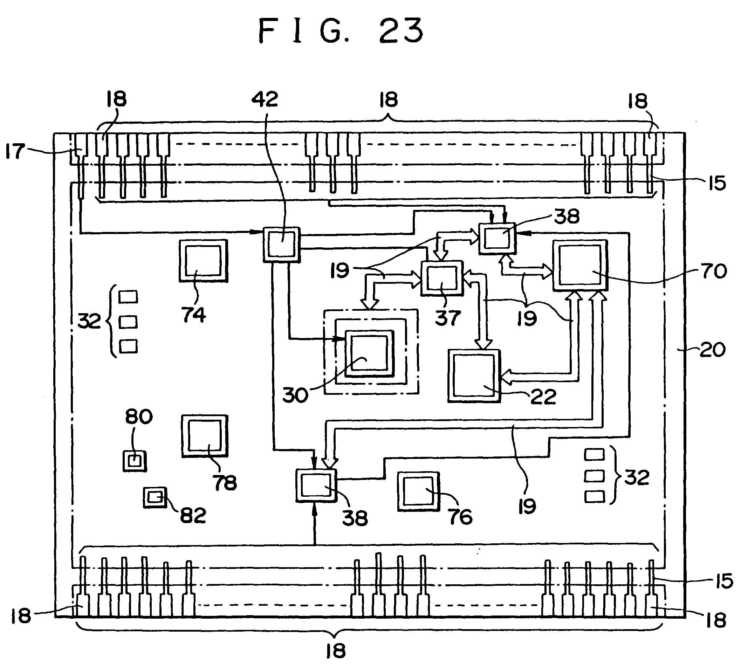

Fig. 23 is a plan drawing of the integrated circuit substrate 20 mounting a MODEM. To avoid confusion, conductive paths which interconnect the circuit elements are omitted, but a part of them is shown as the bus lines 19.

The pads 17 to which the EPROM external leads 52 (omitted from the drawing) are secured and the pads 18 to which the common external leads 54 are secured are formed on both peripheral ends in opposition of the integrated circuit substrate 20. The conductive paths 15 are formed, connecting to each of the pads 17, 18. The microcomputer 22; the DTE interface 70; the first and second modulator-demodulator circuits 74, 76; the DTMF generator circuit 78; the chip parts 32 such as condensers and the like; the EPROM 30 which feeds data to the microcomputer 22; and the first and second gates 37,38 are secured to the integrated circuit substrate 20. The bus lines 19 constituted of the specified conductive paths 15 interconnects the microcomputer 22 with the DTE interface 70 which is one of the peripheral circuit elements 32. The first and second gates 37, 38 selectively connect the EPROM 30 to the microcomputer 22 or to the pads 18 to which the common external leads 54 are secured. The peripheral circuit elements 32 are selectively connected, through the second gate 38, with the pads 18 to which the common external leads 54 are secured.

This embodiment has, besides the effect in the previous embodiment, an advantage of reduction in number in external leads, because almost all external leads are commonly used. This embodiment has also an advantage of facilitating pattern designing of the integrated circuit substrate 20 due to the reduction of an area occupied by the conductive paths 15, when the microcomputer 22, EPROM 30, and the first and second gates 37, 38 are positioned close to each other.

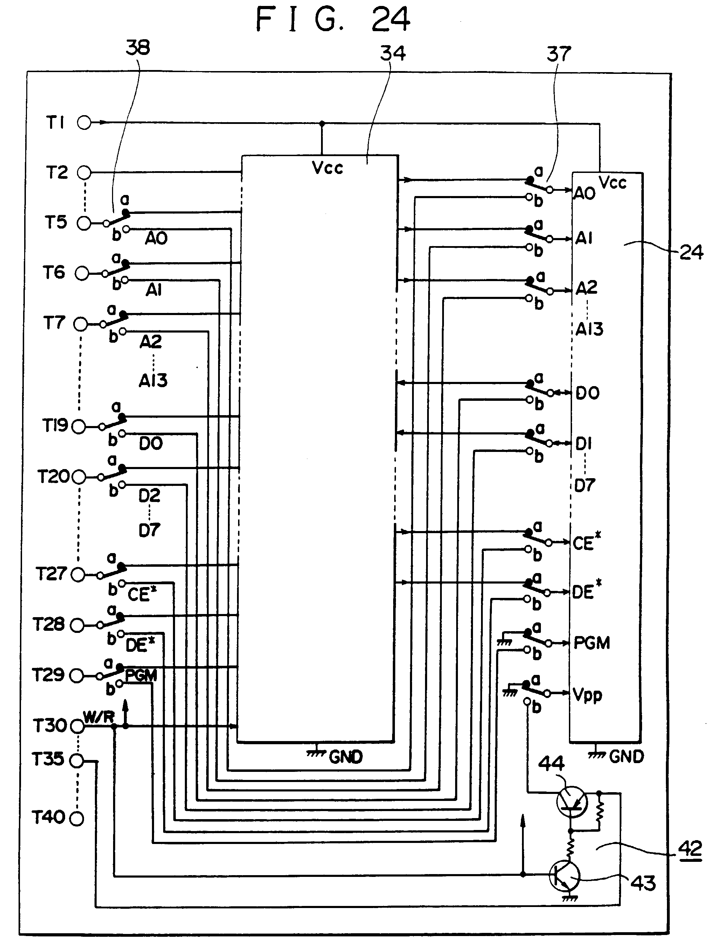

In this embodiment, a microcomputer with a built-in EPROM can also be used. Fig. 24 is a block diagram for explaining the integrated circuit device mounting the microcomputer with a built-in EPROM. Except for using the reference number of 24 for the microcomputer with a built-in EPROM, the same numbers as in Fig. 22 are used for circuit elements. In this embodiment, the microcomputer 24 with a built-in EPROM is positioned in the same place as the EPROM 30 in the previous embodiment.

In the above third embodiment, the number of external leads is remarkably reduced. However, external leads must be provided for the control signal R/W which controls two modes, that is, a regular mode in which essential operation is executed and a data-writing mode. The following is an explanation for a modification of this embodiment which does not require the external leads for the control signal R/W.

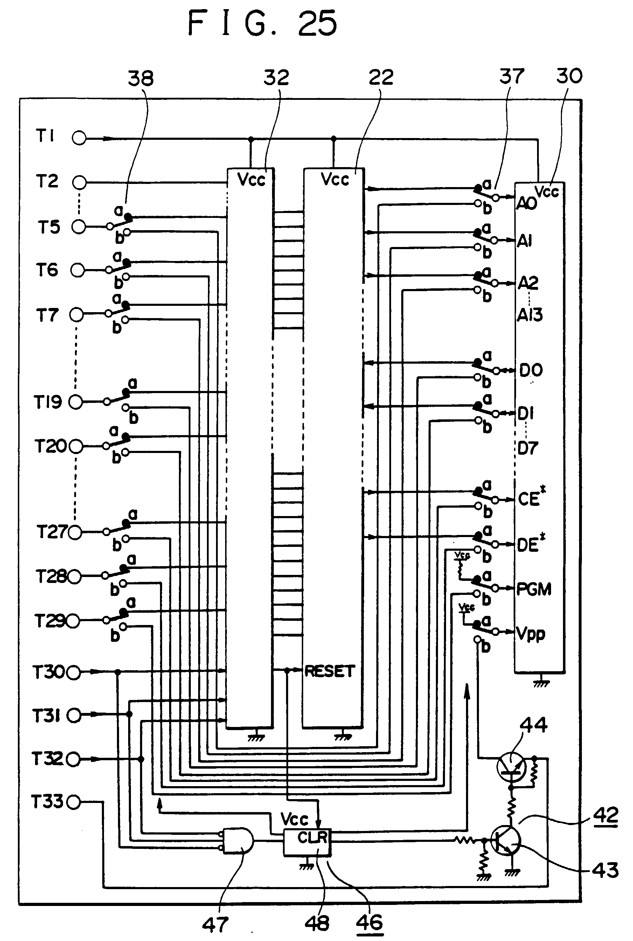

Fig. 25 is a block diagram for explaining the modification. Fig. 21 is again adopted to show the outward form of the modification.

Referring to Fig. 25, the modification is provided with the microcomputer 22; the plurality of circuit elements expressed by the peripheral circuit element block 34; the EPROM 30; and a mode-determining circuit 46 constituted of a multiple-input AND gate 47 and a flip-flop 48.

Terminals T1-T32 are those connected to the common external leads 54 of the integrated circuit device 10. Among them, only the terminal T32 supplied with Vₚₚ of +21V is connected to the EPROM external lead 52. This means that the number of the EPROM external lead 52 in this modification is only one. As is clear from the drawing in comparison with Fig. 22, this modification and the embodiment shown in the block diagram Fig. 22 is almost equivalent except that this modification is provided with the mode-determining circuit, but no terminal for control signal R/W.

In this modification, the hybrid integrated circuit device 10 with a microcomputer is provided, besides the address electrodes A0-A13 and the data terminals D0-D7 shown in the drawing, specific external leads including external leads for system controls, e.g. resetting, halt instruction; external leads for system controls, e.g. interrupt control, or the like, which are connected with the terminals T30-T32 to control the microcomputer. Here, it is premised that, among signals input in these terminals T30-T32, there certainly exists a combination of the signals which generates a specific combination of logical levels in which the terminals T30, T31, and T32 are not respectively, for example, at a LOW level, a HIGH level, and a LOW level, at the same time in a regular operation mode. Such a logical combination can also be found from combinations of outputs from the address electrodes A0-A13 and data terminals D0-D7.

In this respect, logical levels impossible in the regular operation mode are respectively input in the terminals T30-T32 to set out a data-writing mode for the EPROM 30 of this modification. Here, when inputting a LOW level in the terminal T30, a HIGH level in the terminal T31, and a LOW level in the terminal T32, the multiple-input AND gate 47 which constitute the mode-determining circuit 46 outputs a HIGH level, and the flip-flop 48 is set up. Then, according to the output from the flip-flop 48, the system of this modification is changed to the writing mode for the EPROM 30. While, the regular operation mode can be set by clearing the set of the flip-flop 48 by the measure of the reset signal (RESET) of the microcomputer 22.

A microcomputer with a built-in EPROM can also be used in this modification.

With this modification as explained above, besides the effect in the previous embodiment, an advantage of extremely reducing external leads can be given.

## Claims

1. A hybrid integrated circuit device (10) comprising:
an integrated circuit substrate (20) provided with external leads (50) on its periphery and with conductive paths (15) formed on said substrate;
a microcomputer chip (22) and peripheral circuit elements (32) mounted on said substrate;
a non-volatile memory chip (30) mounted on said substrate;
a box-shaped casing (56) made from a thermoplastic resin being secured to said substrate and having a walled opening above the non-volatile memory chip, the walls (57) of said opening extending to said substrate and being sealed thereon whereby a sealed space (59) for said microcomputer chip and said peripheral circuit elements is formed;
wherein a first resin layer (60) and a second resin layer (62) are filled in a space (58) enclosed by the walls (57) of the opening to seal the non-volatile memory chip; and
said microcomputer chip and said peripheral circuit elements are interconnected by said conductive paths and said microcomputer chip and said non-volatile memory chip which feeds data to the microcomputer are independently connected to respective external leads via conductive paths inside the casing.

2. The hybrid integrated circuit device of Claim 1, wherein the integrated circuit substrate is a metal substrate for which the surface has been subjected to an insulating treatment, and the conductive paths is formed by applying a copper foil.

3. The hybrid integrated circuit device of Claim 1, wherein chip-formed resistors or chip-formed condensors are used as one of the peripheral circuit elements.

4. The hybrid integrated circuit device of Claim 1, wherein the space enclosed by the walls of the opening is almost the same size as the non-volatile memory; and the first resin layer (60) is a UV-light transmitting resin layer formed on the upper surface of the non-volatile memory chip in the space and the second resin layer (62) is a non-UV-light transmitting layer or a light-shielding seal material.

5. The hybrid integrated circuit device of Claim 1, wherein the microcomputer is a microcomputer with a built-in memory.

6. A hybrid integrated circuit device (10) comprising:
an integrated circuit substrate (20) provided with external leads (50) on its periphery and with conductive paths (15) formed on said substrate;
a microcomputer chip (22), a gate (36) and peripheral circuit elements (32) mounted on said substrate;
a non-volatile memory chip (30) mounted on said substrate;
a box-shaped casing (56) made from a thermoplastic resin being secured to said substrate and having a walled opening above the non-volatile memory chip, the walls (57) of said opening extending to said substrate and being sealed thereon whereby a sealed space (59) for said microcomputer chip, said gate (36) and said peripheral circuit elements is formed;
wherein a first resin layer (60) and a second resin layer (62) are filled in a space (58) enclosed by the walls (57) of the opening to seal the non-volatile memory chip; and
said microcomputer chip, said gate (36) and said peripheral circuit elements are interconnected by said conductive paths and said non-volatile memory chip which feeds data to the microcomputer is selectively connected through said gate (36) to the microcomputer or to respective external leads of the non-volatile memory via conductive paths inside the casing.

7. A hybrid integrated circuit device (10) comprising:
an integrated circuit substrate (20) provided with external leads (50) on its periphery and with conductive paths (15) formed on said substrate;
a microcomputer chip (22), a first gate (37), a second gate (38) and peripheral circuit elements (32) mounted on said substrate;a non-volatile memory chip (30) mounted on said substrate;
a box- shaped casing (56) made from a thermoplastic resin being secured to said substrate and having a walled opening above the non-volatile memory chip, the walls (57) of said opening extending to said substrate and being sealed thereon whereby a sealed space (59) for said microcomputer chip, said first gate (37), said second gate (38) and said peripheral circuit elements is formed;
wherein a first resin layer (60) and a second resin layer (62) are filled in a space (58) enclosed by the walls (57) of the opening to seal the non-volatile memory chip; and
said microcomputer chip, said first gate (37), said second gate (38) and said peripheral circuit elements are interconnected by said conductive paths and said non-volatile memory chip which feeds data to the microcomputer is selectively connected through said first gate (37) to the microcomputer or through said second gate (38) to the external leads via conductive paths inside the casing, and the second gate (38) selectively connects common external leads to the peripheral circuit elements or to the non-volatile memory chip through said first gate (37) via conductive paths inside the casing.

## Patentansprüche

1. Integrierte Hybridschaltungsanordnung (10) mit:
- einem Substrat (20) für eine integrierte Schaltung, das an seinem Rand mit externen Zuleitungen (50) und mit auf dem Substrat ausgebildeten leitenden Pfaden (15) versehen ist;
- einem Mikrocomputerchip (22) und peripheren Schaltungselementen (22), die auf dem Substrat montiert sind;
- einem Chip (30) eines nichtflüchtigen Speichers, der auf dem Substrat montiert ist;
- einer kastenförmigen Umkleidung (56) aus einem thermoplastischen Harz, die am Substrat befestigt ist und eine Öffnung mit Wand über dem Chip eines nichtflüchtigen Speichers aufweist, wobei sich die Wände (57) dieser Öffnung zum Substrat erstrecken und sie dort abgedichtet sind, wodurch ein abgedichteter Raum (59) für den Mikrocomputerchip und die peripheren Schaltungselemente gebildet ist;
- wobei eine erste Harzschicht (60) und eine zweite Harzschicht (62) in einen durch die Wände (57) der Öffnung umschlossenen Raum (58) eingefüllt sind, um den Chip eines nichtflüchtigen Speichers abzudichten; und wobei der Mikrocomputerchip und die peripheren Schaltungselemente über die leitenden Pfade miteinander verbunden sind und der Mikrocomputerchip und der Chip eines nichtflüchtigen Speichers, der Daten an den Mikrocomputer liefert, unabhängig mit jeweiligen externen Zuleitungen über leitende Pfade innerhalb der Umkleidung verbunden sind.

2. Integrierte Hybridschaltungsanordnung nach Anspruch 1, bei der das Substrat für eine integrierte Schaltung ein Metallsubstrat ist, dessen Oberfläche einer Isolierbehandlung unterzogen wurde, und bei dem die leitenden Pfade durch Auftragen einer Kupferfolie ausgebildet sind.

3. Integrierte Hybridschaltungsanordnung nach Anspruch 1, bei der chipförmige Widerstände oder chipförmige Kondensatoren als eine Art peripherer Schaltungselemente verwendet sind.

4. Integrierte Hybridschaltungsanordnung nach Anspruch 1, bei der von den Wänden der Öffnung umschlossene Raum beinahe dieselbe Größe wie der nichtflüchtige Speicher hat und die erste Harzschicht (60) eine UV-Licht durchlassende Harzschicht ist, die an der Oberseite des Chips eines nichtflüchtigen Speichers im Raum ausgebildet ist und die zweite Harzschicht (62) eine kein UV-Licht durchlassende Schicht oder ein lichtabschirmendes Abdichtungsmaterial ist.

5. Integrierte Hybridschaltungsanordnung nach Anspruch 1, bei der der Mikrocomputer ein solcher mit eingebautem Speicher ist.

6. Integrierte Hybridschaltungsanordnung (10) mit:
- einem Substrat (20) für eine integrierte Schaltung, das an seinem Rand mit externen Zuleitungen (50) und mit auf dem Substrat ausgebildeten leitenden Pfaden (15) versehen ist;
- einem Mikrocomputerchip (22), einem Gate (36) und peripheren Schaltungselementen (32), die auf dem Substrat montiert sind;
- einem Chip (30) eines nichtflüchtigen Speichers, der auf dem Substrat montiert ist;
- einer kastenförmigen Umkleidung (56) aus einem thermoplastischen Harz, die am Substrat befestigt ist und eine umwandete Öffnung über dem Chip eines nichtflüchtigen Speichers aufweist, wobei sich die Wände (57) der Öffnung zum Substrat erstrecken und auf diesem abgedichtet sind, wodurch ein abgedichteter Raum (59) für den Mikrocomputerchip, das Gate (36) und die peripheren Schaltungselemente ausgebildet ist;
- wobei eine erste Harzschicht (60) und eine zweite Harzschicht (62) in einen von den Wänden (57) der Öffnung umschlossenen Raum (58) eingefüllt sind, um den Chip eines nichtflüchtigen Speichers abzudichten; und wobei der Mikrocomputerchip, das Gate (36) und die peripheren Schaltungselemente über die leitenden Pfade miteinander verbunden sind und der Chip eines nichtflüchtigen Speichers, der Daten an den Mikrocomputer liefert, über das Gate (36) wahlweise mit dem Mikrocomputer oder den jeweiligen externen Zuleitungen des nichtflüchtigen Speichers über leitende Pfade innerhalb des Gehäuses verbunden wird.

7. Integrierte Hybridschaltungsanordnung (10) mit:
- einem Substrat (20) für eine integrierte Schaltung, das an seinem Rand mit externen Zuleitungen (50) und mit auf dem Substrat ausgebildeten leitenden Pfaden (15) versehen ist;
- einem Mikrocomputerchip (22), einem ersten Gate (37), einem zweiten Gate (38) und peripheren Schaltungselementen (32), die auf dem Substrat montiert sind;
- einem Chip (30) eines nichtflüchtigen Speichers, der auf dem Substrat montiert ist;
- einer kastenförmigen Umkleidung (56) aus einem thermoplastischen Harz, die am Substrat befestigt ist und eine umwandete Öffnung über dem Chip eines nichtflüchtigen Speichers aufweist, wobei sich die Wände (57) der Öffnung zum Substrat erstrecken und auf diesem abgedichtet sind, wodurch ein abgedichteter Raum (59) für den Mikrocomputerchip, das erste Gate (37), das zweite Gate (38) und die peripheren Schaltungselemente ausgebildet ist;
- wobei eine erste Harzschicht (60) und eine zweite Harzschicht (62) in einen von den Wänden (57) der Öffnung umschlossenen Raum (58) eingefüllt sind, um den Chip eines nichtflüchtigen Speichers abzudichten; und wobei der Mikrocomputerchip, das erste Gate (37), das zweite Gate (38) und die peripheren Schaltungselemente über die leitenden Pfade miteinander verbunden sind und der Chip eines nichtflüchtigen Speichers, der Daten an den Mikrocomputer liefert, wahlweise über das erste Gate (37) mit dem Mikrocomputer oder das zweite Gate (38) mit den externen Zuleitungen, mittels leitender Pfade innerhalb des Gehäuses, verbunden wird, und das zweite Gate (38) wahlweise gemeinsamen externe Anschlüsse mit den peripheren Schaltungselementen oder dem Chip eines nichtflüchtigen Speichers über das erste Gate (37) mittels leitender Pfade innerhalb des Gehäuses verbindet.

## Revendications

1. Dispositif à circuit intégré hybride (10) comprenant :
un substrat de circuit intégré (20) muni de lignes externes (50) sur sa périphérie et de chemins conducteurs (15) formés sur ledit substrat ;
une puce de microcalculateur (22) et des éléments de circuit périphérique (32) montés sur ledit substrat ;
une puce de mémoire non volatile (30) montée sur ledit substrat ;
un boîtier en forme de boîte (56), fait d'une résine thermoplastique, solidement fixé audit substrat et ayant une ouverture à paroi au-dessus de la puce de mémoire non volatile, les parois (57) de ladite ouverture s'étendant vers ledit substrat et étant scellées sur ce dernier, de sorte qu'un espace scellé (59), pour ladite puce de microcalculateur et pour lesdits éléments de circuit périphérique, soit formé ;
dans lequel une première couche de résine (60) et une seconde couche de résine (62) sont versées dans un espace (58) enfermé par les parois (57) de l'ouverture pour sceller la puce de mémoire non volatile ; et
ladite puce de microcalculateur et lesdits éléments de circuit périphérique sont interconnectés par lesdits chemins conducteurs, et ladite puce de microcalculateur et ladite puce de mémoire non volatile, qui délivre les données au microcalculateur, sont reliées de façon indépendante aux lignes externes respectives par l'intermédiaire de chemins conducteurs à l'intérieur du boîtier.

2. Dispositif à circuit intégré hybride selon la revendication 1, dans lequel le substrat de circuit intégré est un substrat de métal pour lequel la surface a été soumise à un traitement d'isolation, et les chemins conducteurs sont formés en appliquant une feuille de cuivre.

3. Dispositif à circuit intégré hybride selon la revendication 1, dans lequel des résistances sous forme de puce ou des condensateurs sous forme de puce sont utilisés en tant qu'un des éléments de circuit périphérique.

4. Dispositif à circuit intégré hybride selon la revendication 1, dans lequel l'espace enfermé par les parois de l'ouverture est presque de la même taille que la mémoire non volatile ; et la première couche de résine (60) est une couche de résine de transmission de rayonnement ultraviolet formée sur la surface supérieure de la puce de mémoire non volatile dans l'espace, et la seconde couche de résine (62) est une couche de résine de transmission de rayonnement non ultraviolet ou une matière de scellement de protection contre la lumière.

5. Dispositif à circuit intégré hybride selon la revendication 1, dans lequel le microcalculateur est un microcalculateur ayant une mémoire intégrée.

6. Dispositif à circuit intégré hybride (10) comprenant :
un substrat de circuit intégré (20) muni de lignes externes (50) sur sa périphérie et de chemins conducteurs (15) formés sur ledit substrat ;
une puce de microcalculateur (22), une porte (36) et des éléments de circuit périphérique (32) montés sur ledit substrat ;
une puce de mémoire non volatile (30) montée sur ledit substrat ;
un boîtier en forme de boîte (56) fait d'une résine thermoplastique solidement fixée audit substrat et ayant une ouverture à paroi au-dessus de la puce de mémoire non volatile, les parois (57) de ladite ouverture s'étendant vers ledit substrat et étant scellées sur ce dernier, de sorte qu'un espace scellé (59), pour ladite puce de microcalculateur, pour ladite porte (36) et pour lesdits éléments de circuit périphérique, soit formé ;
dans lequel une première couche de résine (60) et une seconde couche de résine (62) sont versées dans un espace (58) enfermé par les parois (57) de l'ouverture pour sceller la puce de mémoire non volatile ; et
ladite puce de microcalculateur, ladite porte (36) et lesdits éléments de circuit périphérique sont interconnectés par lesdits chemins conducteurs, et ladite puce de mémoire non volatile, qui délivre les données au microcalculateur, est reliée, de manière sélective, par l'intermédiaire de ladite porte (36) au microcalculateur ou aux lignes externes respectives de la mémoire non volatile par l'intermédiaire de chemins conducteurs à l'intérieur du boîtier.

7. Dispositif à circuit intégré hybride (10) comprenant :
un substrat de circuit intégré (20) muni de lignes externes (50) sur sa périphérie et de chemins conducteurs (15) formés sur ledit substrat ;
une puce de microcalculateur (22), une première porte (37), une seconde porte (38) et des éléments de circuit périphérique (32) montés sur ledit substrat ; une puce de mémoire non volatile (30) montée sur ledit substrat ;
un boîtier en forme de boîte (56) fait d'une résine thermoplastique solidement fixée audit substrat et ayant une ouverture à paroi au-dessus de la puce de mémoire non volatile, les parois (57) de ladite ouverture s'étendant vers ledit substrat et étant scellées sur ce dernier, de sorte qu'un espace scellé (59), pour ladite puce de microcalculateur, pour ladite première porte (37), pour ladite seconde porte (38) et pour lesdits éléments de circuit périphérique, soit formé ;
dans lequel une première couche de résine (60) et une seconde couche de résine (62) sont versées dans un espace (58) enfermé par les parois (57) de l'ouverture pour sceller la puce de mémoire non volatile ; et
ladite puce de microcalculateur, ladite première porte (37), ladite seconde porte (38) et lesdits éléments de circuit périphérique sont interconnectés par lesdits chemins conducteurs, et ladite puce de mémoire non volatile, qui délivre les données au microcalculateur, est reliée, de manière sélective, par l'intermédiaire de ladite première porte (37) au microcalculateur ou par l'intermédiaire de ladite seconde porte (38) aux lignes externes par l'intermédiaire de chemins conducteurs à l'intérieur du boîtier, et la seconde porte (38) relie, de manière sélective, les lignes externes communes aux éléments de circuit périphérique ou à la puce de mémoire non volatile par l'intermédiaire de ladite première porte (37) via les chemins conducteurs à l'intérieur du boîtier.
